# EUROPEAN PATENT SPECIFICATION

(11) **EP 2 538 275 B1**
(45) Date of publication and mention of the grant of the patent: **29.10.2014**
(21) Application number: 11744771.4
(22) Date of filing: 18.02.2011
(51) Int. Cl.: G03F 7/095, G03F 7/00, G03F 7/004, G03F 7/039, G03F 7/32, B41C 1/10

(54) **PROCESS FOR MAKING LITHOGRAPHIC PRINTING PLATE**
VERFAHREN ZUR HERSTELLUNG EINER LITHOGRAFIEDRUCKPLATTE
PROCÉDÉ DE FABRICATION D'UNE PLAQUE D'IMPRESSION LITHOGRAPHIQUE

(30) Priority: 19.02.2010 JP 2010035192
(43) Date of publication of application: 26.12.2012
(73) Proprietor: FUJIFILM Corporation, Tokyo 106-8620 (JP)
(72) Inventor: SHIRAISHI, Yuichi, Haibara-gun Shizuoka 421-0396 (JP)
(74) Representative: HOFFMANN EITLE
(86) International application number: PCT/JP2011/053562
(87) International publication number: WO 2011/102485

(56) References cited:
- EP-A2- 2 357 530
- WO-A2-2008/048432
- JP-A- 2 007 055
- JP-A- 2006 126 476
- JP-A- 2007 017 913
- JP-A- 2008 064 959
- JP-A- 2008 076 516
- JP-A- 2009 085 983
- US-A1- 2009 186 301

## Description

### Technical Field

The present invention relates to a method for manufacturing a planographic printing plate, and in particular, to a method for manufacturing a planographic printing plate having excellent process ability.

### Background Art

In general, planographic printing plates have a lipophilic image portion that receives an ink during printing process and a hydrophilic non-image portion that receives dampening water. Planographic printing is a printing method in which, by utilizing the repelling property between water and a printing ink, difference in ink adhesiveness at the surface of a planographic printing plate is generated by using a lipophilic image portion of a planographic printing plate as an ink receiving portion and a hydrophilic non-image portion as a dampening water receiving portion (an ink non-receiving portion), and an ink is adhered only to the image portion, followed by transferring the ink to a printing substrate such as a paper.

For manufacturing such a planographic printing plate, a planographic printing plate precursor (PS plate) provided with a lipophilic photosensitive resin layer (a photosensitive layer, an image recording layer) on a hydrophilic support is conventionally widely used. Usually, a planographic printing plate is obtained by plate making in such a manner that an exposure step is carried out in which a planographic printing plate precursor is subjected to a pattern light exposure via an original picture such as lith film, a development step is then carried out in which a portion to become an image portion of an image recording layer is left and the other unnecessary portion of the image recording layer is dissolved and removed using an alkaline developer or an organic solvent, so that a non-image portion is formed by exposing the surface of the hydrophilic support.

As described above, in the conventional plate-making steps for a planographic printing plate precursor, a development step in which unnecessary portion of the image recording layer is dissolved and removed using a developer or the like is necessary after the exposure. Thus, it is desired that, from the viewpoints of environment and safety, an aqueous solution having a pH near the neutral region be used as an aqueous alkali solution used for development, or the amount of waste solution generated in the development step be reduced. In particular, in consideration of global environment, disposal of waste solution released accompanied with a wet processing treatment has been of major industry-wide concern. Thus, the need for solving the above-mentioned problems is ever-increasing.

On the other hand, recently, digitization techniques including electrically processing, storing and outputting image information using a computer are widely used, and a variety of new image output methods compatible with such digitization techniques have been put to practical use. Accompanying this, a Computer-To-Plate (CTP) technique has been attracting attention in which digitized image information is superimposed on a highly convergent radiant ray such as a laser beam, and a planographic printing plate precursor is subjected to a scanning exposure with the ray to directly manufacture a planographic printing plate without mediating a lith film. In particular, an image recording material compatible with an infrared laser is prevalent because it can be used under white light. Examples of such an image recording material include a positive-working image recording material utilizing a solubility inhibition effect against a developer, which is exerted owing to an infrared absorbing dye having photothermal conversion effect and a phenol resin, and such material has been attracting attention.

Usually, in such a positive-working image recording material, the solubility of the image recording layer is improved by eliminating the solubility inhibition effect by an infrared laser exposure and heat generated by a photothermal conversion agent in the exposed region, followed by removing the region in a development step, whereby a planographic printing plate is produced. After the development, generally, a water-washing treatment is performed to remove an excessive alkaline developer. Subsequently, the planographic printing plate is rubberized to be used for printing.

The development treatment is usually performed using an automatic developing machine, and when the image recording layer dissolved in a developer increases, precipitation occurs to yield development scum. When the generation of development scum is considerable, the scum may adhere to a manufactured planographic printing plate, which may cause an image failure. In particular, since, for an image recording layer compatible with an infrared laser, a photothermal conversion agent having a relatively high molecular weight is used, and for a planographic printing plate for applications with high printing durability, those having a strong cohesive force as a polymer binder and having a high molecular weight are used, the development scum tends to be generated.

Further, it is preferable that the alkaline developer to be used in the development step have a pH near neutral from the viewpoint of environment, and a variety of trials have been made. For example, a plate-making method is proposed in which a planographic printing plate precursor having a positive-working image recording layer with a multilayered structure is treated with a developer having a pH of 6 to 11 (see, for example, WO2009/094120A1). There is, however, a problem in that, when plate-making is repeatedly carried out using an automatic developing machine, by only controlling the pH of the alkaline developer low, the development scum increase owing to a decrease in development property, that is, the solubility of the image recording layer. It has been found that the development scum adheres to the surface of the manufactured printing plate, which may cause an image failure.

Further, in the planographic printing plate, in order to increase the hydrophilicity of the non-image portion and to protect the plate surface, it is usually preferable that the plate surface after development and water washing is subjected to a hydrophilizing treatment, which is also referred to as a gumming treatment. Since the gumming treatment is also a wet treatment, there is also a similar problem of waste solution as in the development step. Document EP 2357530 A2 provides is a method of producing a planographic printing plate, including: subjecting a planographic printing plate precursor, which has a support and a positive-working image recording layer, to image-wise exposure; and developing it using an alkaline aqueous solution which contains a specific compound and has a pH of from 8.5 to 10.8, in this order.Document US 2009/0186301 discloses a multi-layer, positive-working lithographic printing plate precursor that can be imaged with infrared radiation and processed in a single step using a single processing solution that has a pH greater than 6 and up to about 11.

### DISCLOSURE OF INVENTION

### Technical Problem

The present invention has been made in consideration of the above mentioned problems, and an object thereof is to provide a method of manufacturing a planographic printing plate, in which the development property is excellent and the generation of development residue over time is inhibited, even when an alkaline developer having a relatively low pH is used.

### Solution to Problem

The method of manufacturing a planographic printing plate of the present invention includes: imagewise exposing (i.e., exposure step) a positive-working planographic printing plate precursor having an image recording layer, the image recording layer having, in this order, a lower layer containing an infrared absorbing agent, an alkali-soluble resin, and a copolymer at least including a structural unit derived from acrylonitrile and a structural unit derived from styrene, and an upper layer containing a water-insoluble and alkali-soluble resin; and developing (i.e., development step) the positive-working planographic printing plate precursor after the imagewise exposure, using an aqueous alkali solution which has a pH of 8.5 to 10.8 and contains an anionic surfactant, in this order.

The alkali-soluble resin contained in the lower layer is preferably an alkali-soluble acrylic resin. The water-insoluble and alkali-soluble resin contained in the upper layer is preferably an alkali-soluble resin selected from the group consisting of an alkali-soluble polyurethane resin, an alkali-soluble resin having a urea bond at a side chain, and an alkali-soluble phenol resin.

The content of the water-soluble polymer compound in the aqueous alkali solution used in the development step is preferably 10 ppm or less.

The development step is preferably a single bath treatment using an aqueous alkali solution.

The manufacturing method of the present invention has an advantage in that the produced planographic printing plate is able to be used for printing as it is after the development step using an aqueous alkali solution having a relatively low pH, without performing a rinsing step, that is, a water-washing step, or without performing a gumming step which are usually widely performed. The manufacturing method of the present invention has an excellent stability in development system because the generation of development scum over time is effectively inhibited even in such a single bath treatment.

### Advantageous Effects of Invention

According to the present invention, a method of manufacturing a planographic printing plate is provided which exerts excellent development property and in which the generation of development scum over time is inhibited, even when an alkaline developer having a relatively low pH is used.

### BRIEF DESCRIPTION OF DRAWINGS

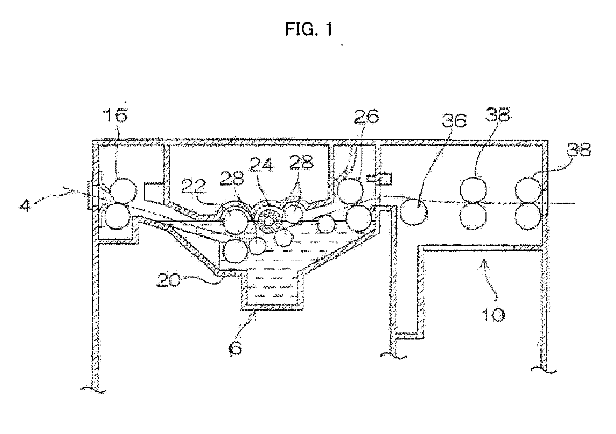

Fig. 1 is a schematic cross-sectional view illustrating one embodiment of the structure of an automatic development apparatus which may be used in the method of manufacturing a planographic printing plate of the present invention.

### DESCRIPTION OF EMBODIMENTS

Hereinbelow, the method of manufacturing a planographic printing plate of the invention will be described in detail.

The method of manufacturing a planographic printing plate of the present invention includes, in the following order:
imagewise exposing (i.e., exposure step) a positive-working planographic printing plate precursor having a support, and an image recording layer having on the support, the image recording layer including, in this order, a lower layer containing an infrared absorbing agent, an alkali-soluble resin, and a copolymer at least including a structural unit derived from acrylonitrile and a structural unit derived from styrene, and an upper layer containing a water-insoluble and alkali-soluble resin; and
developing (i.e., development step) the positive-working planographic printing plate precursor which has undergone the imagewise exposure using an aqueous alkali solution which has a pH of 8.5 to 10.8 and which includes an anionic surfactant.

Hereinbelow, the structure of a planographic printing plate precursor, exposure step and development step, which may be applied to a method of manufacturing of the present invention, will be described sequentially.

### Planographic printing plate precursor

The planographic printing plate precursor which is used in the method of manufacturing of the present invention is a positive-working planographic printing plate precursor having a support and, on the support, an image recording layer including, in this order, a lower layer containing an infrared absorbing agent, an alkali-soluble resin, and a copolymer at least including a structural unit derived from acrylonitrile and a structural unit derived from styrene, and an upper layer containing a water-insoluble and alkali-soluble resin.

In other words, the image recording layer has a multilayered structure including at least two layers having different formulations. The positive-working planographic printing plate precursor according to the present invention is required to have, on a support, the lower layer and the upper layer in the order mentioned above, and may further have another layer such as an undercoat layer, a protection layer or the like, as necessary.

### Lower layer containing infrared absorbing agent, alkali soluble resin, and copolymer at least including structural unit derived from acrylonitrile and structural unit derived from styrene

In the image recording layer of the planographic printing plate precursor according to the present invention, the lower layer which is provided on the support side with respect to the upper layer includes (1-A) an infrared absorbing agent, (1-B) an alkali-soluble resin and (1-C) a copolymer at least including a structural unit derived from acrylonitrile and a structural unit derived from styrene.

### (1-A) Infrared absorbing agent

The infrared absorbing agent used in the present invention is not particularly restricted, and a variety of dyes or pigments known as an infrared absorbing agent may be appropriately selected and used.

As the infrared absorbing agent according to the present invention, known infrared absorbing agents may be used. Examples thereof include azo dyes, metallic complex azo dyes, pyrazolone azo dyes, anthraquinone dyes, phthalocyanine dyes, carbonium dyes, quinone imine dyes, methine dyes and cyanine dyes. In the present invention, among these dyes, those capable of absorbing an infrared ray or far-red ray may be preferably used when recording is performed using a laser irradiating infrared ray or far-red ray.

Examples of such dyes capable of absorbing infrared ray or near-infrared ray include cyanine dyes described in JP-A No. 58-125246, JP-A No. 59-84356, JP-A No. 59-202829, JP-A No. 60-78787 or the like, methine dyes described in JP-A No. 58-173696, JP-A No. 58-181690, JP-A No. 58-194595 or the like, naphthoquinone dyes described in JP-A No. 58-112793, JP-A No. 58-224793, JP-A No. 59-48187, JP-A No. 59-73996, JP-A No. 60-52940, JP-A No. 60-63744 or the like, squarylium dyes described in JP-A No. 58-112792 or the like, and cyanine dyes described in GB Patent No. 434,875 B.

As the dyes, a near-infrared absorbing sensitizer described in US Patent No. 5,156,938 B is also suitably used, and a substituted arylbenzo(thio)pyrylium salt described in US Patent No. 3,881,924 B, a trimethine thiapyrylium salt described in JP-ANo. 57-142645 (US Patent No. 4,327,169 B), a pyrylium compound described in JP-A No. 58-181051, JP-A No. 58-220143, JP-A No. 59-41363, JP-A No. 59-84248, JP-A No. 59-84249, JP-A No. 59-146063 or JP-A No. 59-146061, a cyanine dye describes in JP-A No. 59-216146, a pentamethine thiopyrylium salt described in US Patent No. 4,283,475, a pyrylium compound or the like disclosed in JP-A No. 05-13514 or JP-A No. 05-19702 may be used. Examples of commercially-available dyes which are particularly preferably used include EPOLIGHT III-178, EPOLIGHT III-130, EPOLIGHT III-125 or the like, which are manufactured by Epolin Inc.

Other examples of particularly preferred dyes include near-infrared absorbing dyes represented by the formulae (I) and (II) in US Patent No. 4,756,993 B.

Among these dyes, examples of particularly preferred dyes include cyanine dyes, phthalocyanine dyes, oxonol dyes, squarylium dyes, pyrylium salts, thiopyrylium dyes and nickel thiolate complexes. Further, a cyanine dye represented by the following Formula (a) most preferable because, when the cyanine dye is used for the lower layer of the present invention, the layer has a high polymerization activity, excellent stability and excellent economic efficiency.

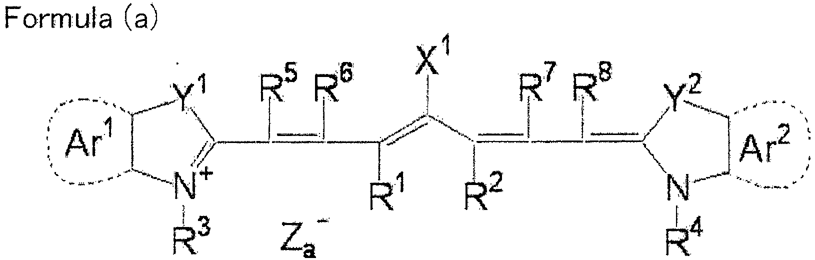

In Formula (a), X¹ represents a hydrogen atom, a halogen atom, -NPh₂, X²-L¹, or the group shown below. Here, X² represents an oxygen atom or a sulfur atom; L¹ represents a hydrocarbon group having 1 to 12 carbon atoms, an aromatic ring having a hetero atom, or a hydrocarbon which has 1 to 12 carbon atoms and contains a hetero atom. Here, the hetero atom indicates N, S, O, a halogen atom or Se.

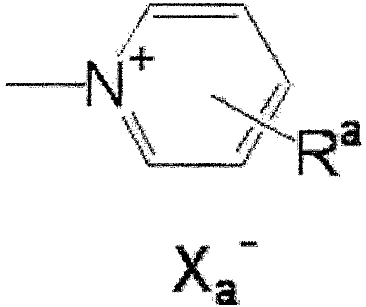

In the above formula, Xa has the same definition as Za described below, and R^{a} represents a substituent selected from the group consisting of a hydrogen atom, an alkyl group, an aryl group, a substituted or unsubstituted amino group and a halogen atom.

In Formula (a), R¹ and R² each independently represents a hydrocarbon group having 1 to 12 carbon atoms. From the viewpoint of the storage stability of a coating liquid for a photosensitive layer, it is preferable that R¹ and R² each independently represent a hydrocarbon group having two or more carbon atoms, and it is particularly preferable that R¹ and R² are bonded to each other to form a 5-member or 6-member ring.

In Formula (a), Ar¹ and Ar² each independently represents an aromatic hydrocarbon group which optionally has a substituent, and Ar¹ and Ar² may be the same as or different from each other. Preferred examples of the aromatic hydrocarbon group include a benzene ring and naphthalene ring. Further, preferred examples of the substituent which Ar¹ or Ar² may have include a hydrocarbon group having 12 or less carbon atoms, a halogen atom, and an alkoxy group having 12 or less carbon atoms.

Y¹ and Y² each independently represents a sulfur atom or a dialkylmethylene group having 12 or less carbon atoms, and Y¹ and Y² may be the same as or different from each other.

R³ and R⁴ each independently represents a hydrocarbon group having 20 or less carbon atoms which may have a substituent, and R³ and R⁴ may be the same as or different from each other. Preferred examples of the substituent that R³ or R⁴ may have include an alkoxy group having 12 or less carbon atoms, a carboxyl group and a sulfo group.

R⁵, R⁶, R⁷ and R⁸ each independently represents a hydrogen atom or a hydrocarbon group having 12 or less carbon atoms, and R⁵, R⁶, R⁷ and R⁸ may be the same as or different from each other. From the viewpoint of the availability of the raw materials, R⁵, R⁶, R⁷ and R⁸ are preferably a hydrogen atom.

Za⁻ represents a counter anion. Note that, when the cyanine dye represented by Formula (a) has an anionic substituent in the structure thereof and it is not necessary to neutralize the electric charge, Za may be absent. From the viewpoint of storage stability, examples of Za preferably include a halogen ion, a perchloric ion, a tetrafluoroborate ion, a hexafluorophosphate ion, and a sulfonic acid ion, and particularly preferably include a perchloric ion, a hexafluorophosphate ion and an aryl sulfonic acid ion.

In the present invention, Specific examples of the cyanine dye represented by Formula (a) which may be suitably used include those described in paragraphs [0017] to [0019] of JP-A No. 2001-133969, in paragraphs [0012] to [0038] of JP-A No. 2002-40638, and in paragraphs [0012] to [0023] of JP-A No. 2002-23360.

A particularly preferred infrared absorbing agent which included in the lower layer is a cyanine dye A below.

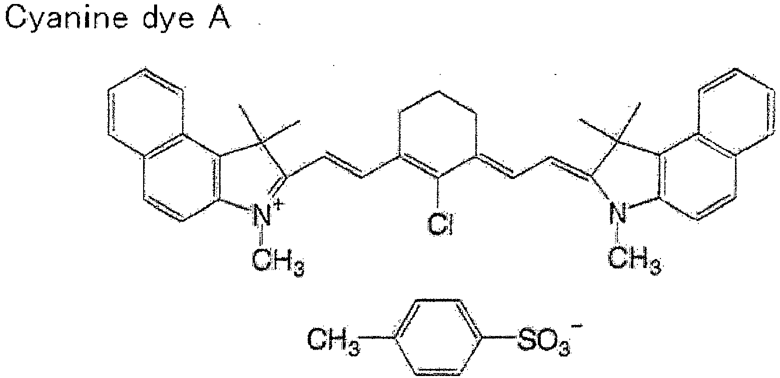

By adding an infrared absorbing agent to the lower layer, the recording sensitivity of the image recording layer is improved.

The amount of the infrared absorbing agent to be added is preferably 0.01 to 50% by mass, more preferably 0.1 to 30% by mass and particularly preferably 1.0 to 30% by mass, with respect to the total solid of the lower layer. When the addition amount is within the above ranges, a high sensitivity is attained and the uniformity and the durability of the lower layer become favorable.

### (1-B) Alkali-soluble resin

Examples of the alkali-soluble resin preferably used for the lower layer of the present invention include a phenol resin and an alkali-soluble acrylic resin.

### 1-B-1: Alkali-soluble acrylic resin

Examples of the alkali-soluble acrylic resin which is preferable for the lower layer include a resin having an acidic group at the main chain or at a side chain in the polymer. Such a resin may be obtained by, for example, polymerizing (or copolymerizing) a monomer mixture including at least one ethylenically unsaturated monomer having an acidic group. Examples of the ethylenically unsaturated monomer having an acidic group useful for forming the alkali-soluble resin include an acrylic acid and a methacrylic acid, as well as monomers represented by the formulae shown below. These ethylenically unsaturated monomers having an acidic group may be used alone, or two or more of these may be used as a mixture.

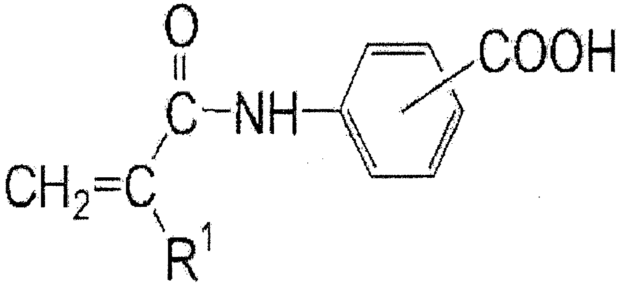

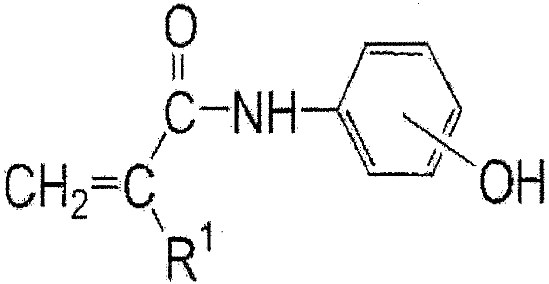

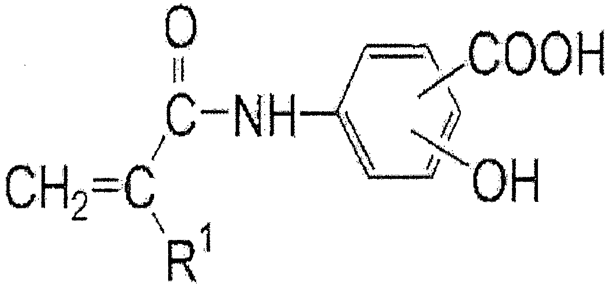

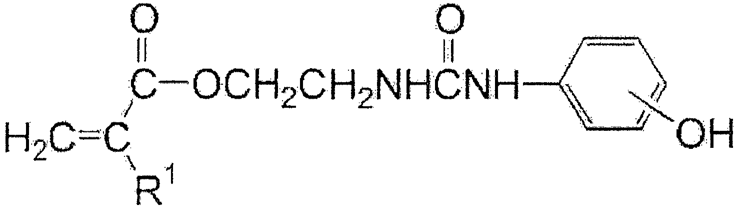

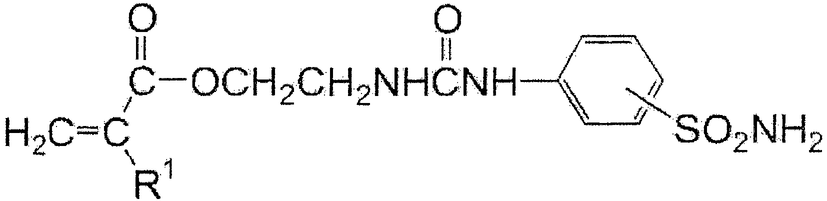

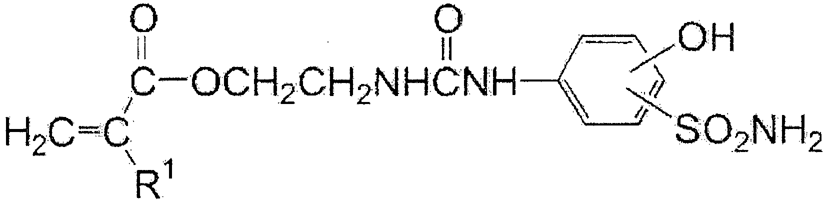

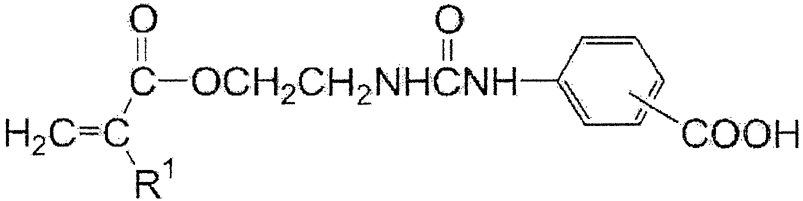

In the above-mentioned formulae, each R¹ independently represents a hydrogen atom or a methyl group.

The alkali soluble resin which is usable for the lower layer of the planographic printing plate precursor in the present invention is preferably a polymer compound obtained by copolymerizing the ethylenically unsaturated monomer having an acidic group (a polymerizable monomer) and another polymerizable monomer (a polymerizable monomer having no acidic group). In this case, regarding the ratio of copolymerization, a polymerizable monomer having an acidic group for providing alkali solubility is preferably contained in an amount of 10 mole% or more, and more preferably contained in an amount of 20 mole% or more and 80 mole% or less.

When the copolymerization ratio of the polymerizable monomer having an acidic group is more than 10 mole%, the alkali solubility of the resin is sufficient for development, and the development property of the obtained planographic printing plate precursor becomes favorable.

Examples of another polymerizable monomer (a polymerizable monomer having no acidic group) which can be used for synthesizing an alkali-soluble resin contained in the lower layer include the compounds mentioned below:
alkyl acrylates and alkyl methacrylates, such as methyl acrylate, ethyl acrylate, propyl acrylate, benzyl acrylate, methyl methacrylate, ethyl methacrylate, cyclohexyl methacrylate, or benzyl methacrylate;
acrylic acid esters and methacrylic acid esters having an aliphatic hydroxyl group, such as 2-hydroxyethyl acrylate or 2-hydroxyethyl methacrylate;
acrylamides and methacrylamides, such as acrylamide, methacrylamide, N-methylacrylamide, N-ethylacrylamide or N-phenylacrylamide;
vinyl esters such as vinyl acetate, vinyl chloroacetate, vinyl butyrate or vinyl benzoate;
styrenes such as styrene, α-methyl styrene, methyl styrene or chloromethyl styrene;
other nitrogen atom-containing monomers such as N-vinylpyrrolidone, N-vinylpyridine, acrylonitrile or methacrylonitrile; and
maleimides such as N-methylmaleimide, N-ethylmaleimide, N-propyhnaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide or N-hydroxyphenylmaleimide.

Among these other polymerizable monomers, (meth)acrylic acid esters, (meth)acrylamides, maleimides and (meth)acrylonitrile are preferably used.

The alkali-soluble acrylic resin which is usable for the lower layer of the present invention is preferably an alkali-soluble acrylic resin having a weight-average molecular weight of 2,000 or more, and having a number-average molecular weight of 500 or more. The alkali-soluble acrylic resin is more preferably an alkali-soluble acrylic resin having a weight-average molecular weight of from 5,000 to 300,000 and having a number-average molecular weight of from 800 to 250,000, and having a dispersity (i.e., weight-average molecular weight/number-average molecular weight) of from 1.1 to 10.

For the lower layer, the alkali-soluble acrylic resins may be used alone, or a combination of two or more thereof may be used.

It is noted that the weight-average molecular weight is the value calculated with respect to the molecular weight of a polystyrene standard by gel permeation chromatography (GPC) measurement. In the present specification, the weight-average molecular weight of a polymer compound is the value obtained in the same manner.

### 1-B-2: Phenol resin

Other preferable examples of alkali soluble resins usable for the lower layer of the present invention include a phenol resin. As the phenol resin which may be used for the lower layer, for example, an alkali-soluble novolac resin is preferable. Examples of the alkali-soluble novolac resin include alkali-soluble novolac resins such as a phenol formaldehyde novolac resin, a m-cresol formaldehyde novolac resin, a p-cresol formaldehyde novolac resin, a m-/p-mixed cresol formaldehyde novolac resin or a phenol/cresol (m-, p-, or m-/p-mixed) mixed formaldehyde novolac resin.

The alkali-soluble novolac resin preferably has a weight-average molecular weight of from 500 to 20,000 and a number-average molecular weight of from 200 to 10,000.

The alkali-soluble resins used for the lower layer may be used alone, and a combination of two or more of these may be used. When a combination of two or more types of the resins is used, two or more types of alkali-soluble acrylic resins may be used in combination, or two or more types of alkali-soluble novolac resins may be used in combination. Alternatively, one or more types of alkali-soluble acrylic resins and one or more types of alkali-soluble novolac resins may be used in combination.

The content (when plural types of resins are used, the total amount thereof) of the alkali-soluble resin with respect to the total solid of the lower layer is, in total, in a range of from 20% by mass to 98% by mass, and preferably in a range of from 25% by mass to 70% by mass. When the amount of the alkali-soluble resin to be added is within the above ranges, both of the durability and the sensitivity of the recording layer become favorable.

### (1-C) Copolymer at least including structural unit derived from acrylonitrile and structural unit derived from styrene

The lower layer of the present invention includes a copolymer at least including a structural unit derived from acrylonitrile and a structural unit derived from styrene (hereinafter, also simply referred to as "copolymer of styrene and acrylonitrile"). The copolymer is not particularly restricted as long as the copolymer is a copolymer obtained by polymerization of at least a copolymer component derived from acrylonitrile and a copolymer component derived from styrene.

Examples of the copolymerization component derived from acrylonitrile include acrylonitrile and methacrylonitrile, and acrylonitrile is preferable among these.

Examples of the copolymerization component derived from styrene include styrene, α-methylstyrene, and p-hydroxystyrene, and any of them may be used favorably.

Regarding the ratio of a copolymerization component derived from acrylonitrile and a copolymerization component derived from styrene, the ratio of a copolymer component derived from acrylonitrile with respect to the total amount of the copolymerization components is preferably from 5% by mass to 50% by weight, and more preferably from 10% by mass to 45% by weight.

A third component other than the copolymer component derived from acrylonitrile and copolymer component derived from styrene may be copolymerized. The component to be copolymerized is not particularly restricted as long as the component is a compound having a copolymerizable C=C bond. Acrylic compounds are preferred, and examples thereof include an alkyl(meth)acrylate having 1 to 6 carbon atoms and a hydroxyalkyl(meth)acrylate having 1 to 6 carbon atoms.

The polymerizable monomer having an acidic group described in the "(1-B-1) Alkali-soluble acrylic resin" may also be favorably used as the component used in combination.

When the other copolymerization component which may be used in combination is used, the amount thereof is from 1% by mass to 30% by weight with respect to the entire copolymer.

The (1-C) copolymer may be synthesized by known radical polymerization, cationic polymerization, anionic polymerization or the like, such as emulsion polymerization, suspension polymerization, solution polymerization, or mass polymerization. The shape of the copolymer is not limited to linear random copolymer, and may be a block copolymer or a graft copolymer.

The (1-C) copolymer in the present invention is commercially available in the trade names, AS resin or SAN, and these commercially available products may be used. Examples of the commercially available products usable in the present invention include "SAN32" manufactured by Bayer AG and "LITAC-A" manufactured by NIPPON A&L INC.

In the present invention, the weight-average molecular weight of the copolymer of acrylonitrile and styrene is preferably from 1,000 to 1,000,000, and more preferably from 3,000 to 300,000.

The content of the copolymer of acrylonitrile and styrene in the lower layer is in a range of from 5 to 80% by mass, and preferably in a range of from 10 to 70% by mass, in terms of solids.

When the content is within the above-mentioned ranges, the image formability becomes favorable.

### Upper layer containing water-insoluble and alkali-soluble resin

The image recording layer of the planographic printing plate precursor has the lower layer as well as an upper layer including a water-insoluble and alkali-soluble resin. The components contained in the upper layer will be described.

### (2-A) Water-insoluble and alkali-soluble resin

Examples of the alkali-soluble resin preferably used for the upper layer in the present invention include an alkali-soluble polyurethane resin, an alkali-soluble resin having a urea bond at a side chain, and an alkali-soluble phenol resin.

### 2-A-1: Alkali-soluble polyurethane resin

In the present invention, the polyurethane resin used for the upper layer is preferably a polyurethane resin having a carboxyl group at a polymer main chain thereof, and specific examples thereof include a polyurethane resin having, as a basic skeleton, a reaction product between a diisocyanate compound represented by the following Formula (I) and a diol compound having a carboxyl group represented by the following Formula (II) or Formula (III).

OCN-R¹-NCO Formula (I)

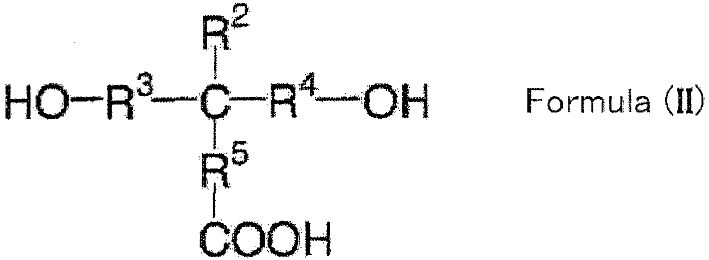

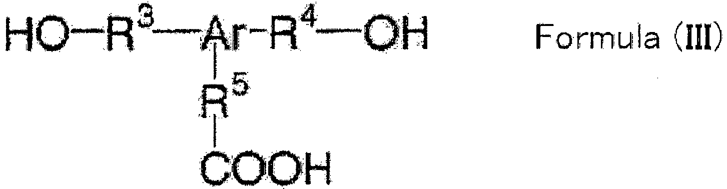

In Formula (I), R¹ represents a divalent hydrocarbon group, and examples thereof preferably include an alkylene group having 2 to 10 carbon atoms and an arylene group having 6 to 30 carbon atoms. R¹ may have another functional group that does not react with an isocyanate group.

In Formula (II), R² represents a hydrogen atom or a hydrocarbon group, and examples thereof preferably include a hydrogen atom, an unsubstituted alkyl group having 1 to 8 carbon atoms and an unsubstituted aryl group having 6 to 15 carbon atoms.

In Formula (II) and Formula (III), R³, R⁴ and R⁵ each independently represents a single bond or a divalent linking group, and examples of the divalent linking group include an aliphatic hydrocarbon group and an aromatic hydrocarbon group, and preferably an unsubstituted alkylene group having 1 to 20 carbon atoms and an unsubstituted arylene group having 6 to 15 carbon atoms, and more preferably an unsubstituted alkylene group having 1 to 8 carbon atoms.

In Formula (III), Ar represents a trivalent aromatic hydrocarbon, and preferably represents an arylene group having 6 to 15 carbon atoms. R¹ to R⁵ and Ar may each further have a substituent that does not react with an isocyanate group.

Specific examples of the diisocyanate compound represented by Formula (I) include:
aromatic diisocyanate compounds such as 2,4-tolylene diisocyanate, a dimer of 2,4-tolylene diisocyanate, 2,6-tolylene diisocyanate, p-xylylene diisocyanate, methaxylylene diisocyanate, 4,4'-diphenylmethane diisocyanate, 1,5-naphthylene diisocyanate, or 3,3'-dimethylbiphenyl-4,4'-diisocyanate;
aliphatic diisocyanate compounds such as hexamethylene diisocyanate, trimethyl hexamethylene diisocyanate, lysine diisocyanate, or dimer acid diisocyanate;
alicyclic diisocyanate compounds such as isophorone diisocyanate, 4,4'-methylenebis(cyclohexyl isocyanate), methyl cyclohexane-2,4- (or -2,6-)diisocyanate, 1,3-(isocyanate methyl) cyclohexane; and
a diisocyanate compound which is a reaction product between diol and diisocyanate, such as an adduct of 1 mole of 1,3-butylene glycol and 2 mole of tolylene diisocyanate.
Among these, a diisocyanate compound having an aromatic ring, such as 4,4'-diphenylmethane diisocyanate, xylylene diisocyanate, or tolylene diisocyanate is preferable from the viewpoint of the printing durability.

Specific examples of the diol compound having a carboxyl group represented by Formula (II) or (III) include:
3,5-dihydroxy benzoic acid, 2,2-bis(hydroxymethyl) propionic acid, 2,2-bis(hydroxyethyl) propionic acid, 2,2-bis(3-hydroxypropyl) propionic acid, 2,2-bis(hydroxymethyl) acetic acid, bis-(4-hydroxyphenyl) acetic acid, 4,4-bis-(4-hydroxyphenyl) pentanoic acid, and tartaric acid.

Among these, 2,2-bis(hydroxymethyl) propionic acid and 2,2-bis(hydroxyethyl) propionic acid are preferred from the viewpoint of the reactivity with isocyanate.

The polyurethane resin according to the present invention may be synthesized by heating the above-mentioned diisocyanate compound and diol compound in an aprotic solvent with addition of a known catalyst having an activity compatible to the reactivity of these compounds.

The molar ratio of diisocyanate and diol compound to be used (i.e., diisocyanate:diol compound) is preferably from 0.8:1 to 1.2:1. If an isocyanate group is left at the polymer terminal, a treatment with an alcohol or amine will be performed, whereby the polyurethane resin is finally synthesized without an isocyanate group being left.

The molecular weight of the alkali soluble polyurethane resin according to the present invention is preferably 1,000 or more, and more preferably from 5,000 to 100,000. Two types of these polyurethane resins may be used in combination.

### 2-A-2: Alkali-soluble resin having urea bond at side chain

The alkali-soluble resin having a urea bond and a phenolic hydroxyl group at a side chain, which is usable for the upper layer in the present invention is not particularly restricted as long as the resin has a urea bond at a side chain thereof and has a phenolic hydroxyl group as a substituent. The alkali-soluble resin is preferably a copolymer including, as a polymerization component, a monomer having a urea bond and a phenolic hydroxyl group from the viewpoint of the manufacturing suitability. As such a monomer, an acrylic monomer having a urea bond and a phenolic hydroxyl group is preferable. Preferable examples of the acrylic monomer include a compound represented by the following Formula (d).

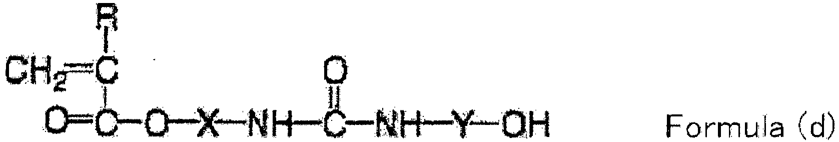

In Formula (d), R represents a hydrogen atom or an alkyl group. X represents a divalent linking group, and examples thereof include an alkylene group or phenylene group which may have a substituent. Y represents a divalent aromatic group which may have a substituent, and examples thereof include a phenylene group or naphthylene group which may have a substituent.

Specific examples of the acrylic monomer represented by Formula (d) include:
acrylate derivatives such as 1-(N'-(4-hydroxyphenyl)ureide)methyl acrylate, 1-(N'-(3-hydroxyphenyl)ureide)methyl acrylate, 1-(N'-(2-hydroxyphenyl)ureide)methyl acrylate, 1-(N'-(3-hydroxy-4-methylphenyl)ureide)methyl acrylate, 1-(N'-(2-hydroxy-5-methylphenyl)ureide)methyl acrylate, 1-(N'-(5-hydroxynaphthyl)ureide)methyl acrylate, 1-(N'-(2-hydroxy-5-phenylphenyl)ureide)methyl acrylate, 2-(N'-(4-hydroxyphenyl)ureide)ethyl acrylate, 2-(N'-(3-hydroxyphenyl)ureide)ethyl acrylate, 2-(N'-(2-hydroxyphenyl)ureide)ethyl acrylate, 2-(N'-(3-hydroxy-4-methylphenyl)ureide)ethyl acrylate, 2-(N'-(2-hydroxy-5-methylphenyl)ureide)ethyl acrylate, 2-(N'-(5-hydroxynaphthyl)ureide)ethyl acrylate, 2-(N'-(2-hydroxy-5-phenylphenyl)ureide)ethyl acrylate, 4-(N'-(4-hydroxyphenyl)ureide)butyl acrylate, 4-(N'-(3-hydroxyphenyl)ureide)butyl acrylate, 4-(N'-(2-hydroxyphenyl)ureide)butyl acrylate, 4-(N'-(3-hydroxy-4-methylphenyl)ureide)butyl acrylate, 4-(N'-(2-hydroxy-5-methylphenyl)ureide)butyl acrylate, 4-(N'-(5-hydroxynaphthyl)ureide)butyl acrylate, or 4-(N'-(2-hydroxy-5-phenylphenyl)ureide)butyl acrylate; and
methacrylate derivatives such as 1-(N'-(4-hydroxyphenyl)ureide) methyl methacrylate, 1-(N'-(3-hydroxyphenyl)ureide) methyl methacrylate, 1-(N'-(2-hydroxyphenyl)ureide) methyl methacrylate, 1-(N'-(3-hydroxy-4-methylphenyl)ureide) methyl methacrylate, 1-(N'-(2-hydroxy-5-methylphenyl)ureide) methyl methacrylate, 1-(N'-(5-hydroxynaphthyl)ureide) methyl methacrylate, 1-(N'-(2-hydroxy-5-phenylphenyl)ureide) methyl methacrylate, 2-(N'-(4-hydroxyphenyl)ureide)ethyl methacrylate, 2-(N'-(3-hydroxyphenyl)ureide)ethyl methacrylate, 2-(N'-(2-hydroxyphenyl)ureide)ethyl methacrylate, 2-(N'-(3-hydroxy-4-methylphenyl)ureide)ethyl methacrylate, 2-(N'-(2-hydroxy-5-methylphenyl)ureide)ethyl methacrylate, 2-(N'-(5-hydroxynaphthyl)ureide)ethyl methacrylate, 2-(N'-(2-hydroxy-5-phenylphenyl)ureide)ethyl methacrylate, 4-(N'-(4-hydroxyphenyl)ureide)butyl methacrylate, 4-(N'-(3-hydroxyphenyl)ureide)butyl methacrylate, 4-(N'-(2-hydroxyphenyl)ureide)butyl methacrylate, 4-(N'-(3-hydroxy-4-methylphenyl)ureide)butyl methacrylate, 4-(N'-(2-hydroxy-5-methylphenyl)ureide)butyl methacrylate, 4-(N'-(5-hydroxynaphthyl)ureide)butyl methacrylate, or 4-(N'-(2-hydroxy-5-phenylphenyl)ureide)butyl methacrylate.

Among these, 2-(N'-(4-hydroxyphenyl)ureide)ethyl methacrylate is preferable from the viewpoints of the inhibition effect on development scum over time, and the balance between the image formability and the printing durability.

For example, in a case in which an alkali-soluble resin having a urea bond at a side chain thereof, which includes an acrylate monomer represented by Formula (d) as a polymer component is synthesized, the content of the monomer to be loaded is preferably in a ratio of from 10 mole% to 80 mole%, more preferably from 15 mole% to 70 mole%, and particularly preferably from 20 mole% to 60 mole%. For the polymerization, the monomer represented by Formula (d) may be used alone, or two or more of these may be used in combination.

The copolymer having a urea bond and a phenolic hydroxyl group at a side chain thereof preferably includes, as a copolymerization component, 10 mole% to 80 mole% of a compound having a polymerizable unsaturated bond and having no urea bond.

The monomer having no urea bond is preferably a N-phenyl maleimide derivative, an acrylic monomer having a sulfonamide group at a side chain, or the like.

Examples of the N-phenyl maleimide derivative include N-phenyl maleimide, N-2-methylphenyl maleimide, N-2,6-diethylphenyl maleimide, N-2-chlorophenyl maleimide and N-hydroxyphenyl maleimide.

Examples of the acrylic monomer having a sulfonamide group at a side chain include m-aminosulfonylphenyl methacrylate, N-(p-aminosulfonylphenyl)methacrylamide, and N-(p-aminosulfonylphenyl)acrylamide. As the polymerizable monomer having no urea bond, monomers other than the above-mentioned N-phenyl maleimides or the acrylic monomer having a sulfonamide group at a side chain may be used. Examples of such monomers which may be included as a copolymerization component in the (A) specific alkali-soluble resin include:
(meth)acrylates such as methyl acrylate, ethyl acrylate, propyl acrylate, butyl acrylate, amyl acrylate, ethyl hexyl acrylate, octyl acrylate, chloroethyl acrylate, 2,2-dimethylhydroxypropyl acrylate, 5-hydroxypentyl acrylate, glycidyl acrylate, benzyl acrylate, tetrahydroacrylate, phenyl acrylate, methyl methacrylate, ethyl methacrylate, propyl methacrylate, benzyl methacrylate, chlorobenzyl methacrylate, octyl methacrylate, 4-hydroxybutyl methacrylate or furfuryl methacrylate;
(meth)acrylamides such as N-methylacrylamide, N-methylmethacrylamide, N-ethylacrylamide, N-propylacrylamide, N-butylacrylamide, N-t-butylacrylamide, N-heptylacrylamide, N-benzylacrylamide, N-phenylacrylamide, N,N-dimethylacrylamide, N-methyl-N-phenylacrylamide, N-ethylmethacrylamide, N-phenylmethacrylamide or N,N-diethylmethacrylamide;
vinyl esters such as vinyl butyrate, vinyl isobutyrate, vinyl trimethyl acetate, vinyl diethyl acetate, vinyl benzoate or vinyl salicylate;
dialkyls of maleic acid or fumaric acid, such as dimethyl malate or dibutyl fumarate;
maleimides such as N-cyclohexylmaleimide or N-laurylmaleimide;
acrylonitrile; and
methacrylonitrile. These compounds may be used alone, or two or more of these may be used in combination.

Among these compounds, (meth)acrylates, (meth)acrylamides, maleimides, and (meth)acrylonitriles are particularly preferable.

Herein, "(meth)acrylate" may be used to indicate any one of acrylate or methacrylate, or both of them, and "(meth)acryl" may be used to indicate any one of acryl or methacryl, or both of them.

A preferred embodiment of the alkali-soluble resin having a urea bond on a side chain in the present invention is a copolymer which is synthesized using 10 mole% to 80 mole% of a monomer represented by Formula (d), 10 mole% to 80 mole% of a monomer selected from N-phenyl maleimide derivatives and acrylic monomers having a sulfonamide group at a side chain, and 10 mole% to 80mole % of another acrylate monomer, which is represented by (meth)acrylates, (meth)acrylamides maleimides and (meth)acrylonitriles.

The weight-average molecular weight of the alkali-soluble resin having a urea bond at a side chain according to the present invention is preferably 2,000 or more, and more preferably from 3,000 to 500,000. The number-average molecular weight thereof is preferably 1,000 or more, and more preferably from 2,000 to 400,000. The molecular weight values are calculated by gel permeation chromatography (GPC) measurement based on the molecular weight of a polystyrene standard.

### 2-A-3: Alkali-soluble phenol resin

In the present invention, examples of the alkali-soluble phenol resin preferably used for the upper layer include novolac resins such as a phenol formaldehyde resin, a m-cresol formaldehyde resin, a p-cresol formaldehyde resin, a m-/p-mixed cresol formaldehyde resin or a phenol/cresol (m-, p-, or m-/p-mixed) mixed formaldehyde resin. A condensation product of a phenol having, as a substituent, an alkyl group having 3 to 8 carbon atoms and formaldehyde, such as a t-butylphenol formaldehyde resin or an octylphenol formaldehyde resin may also be used in combination with the above resin.

Regarding the molecular weight, the alkali-soluble phenol resin preferably has a weight-average molecular weight of from 500 to 20,000 and a number-average molecular weight of from 200 to 10,000.

The content of the water insoluble and alkali soluble resin contained in the upper layer according to the present invention is preferably from 2 to 99.5% by mass, more preferably from 5 to 99% by mass, and particularly preferably from 10 to 98% by mass, with respect to the total solid. When the content is within the above ranges, the development property becomes favorable and generation of development scum is effectively inhibited.

### (2-B) Other alkali-soluble resin

For the upper layer of the present invention, other resins may be used in combination in addition to the water-insoluble and alkali-soluble resin, to an extent that the effect of the present invention is not impaired.

Since the upper layer itself is required to exert alkali solubility particularly in a non-image portion region, a resin which does not deteriorate the property needs to be selected. From this viewpoint, the resin which may be used in combination may contain the alkali-soluble resins other than the specific water-insoluble and alkali-soluble resin, which are illustrated in "(2-A)" above.

Other generally-used alkali-soluble resins which may be used in the present invention will be described below. In particular, preferable examples thereof include a polyamide resin, an epoxy resin, a polyacetal resin, an acrylic resin, a methacrylic resin, and a polystyrene resin.

The amount of other alkali-soluble resin to be mixed is preferably 50% by mass or less with respect to the (2-A) water-insoluble and alkali-soluble resin.

### 3. Other components

To the upper layer or the lower layer constituting the image recording layer according to the present invention, various additives other than the above-mentioned essential components may be further added as required as long as the effect of the present invention is not impaired. The additives mentioned below may be added only to the lower layer, only to the upper layer, or to both layers.

### 3-A: Development accelerator

For the purpose of accelerating the development of an exposed portion and improving the sensitivity, at least one selected from acid anhydrides, phenols and organic acids may be added to the upper layer or lower layer which is included in the recording layer according to the present invention.

As the acid anhydrides, cyclic acid anhydrides are preferred, and specific examples of the cyclic acid anhydrides include phthalic anhydride, tetrahydrophthalic anhydride, hexahydrophthalic anhydride, 3,6-endoxy tetrahydrophthalic anhydride, tetrachlorophthalic anhydride, maleic anhydride, chloromaleic anhydride, α-phenylmaleic anhydride, succinic anhydride, pyromellitic dianhydride, and the like as described in US Patent No. 4,115,128 B. Examples of non-cyclic acid anhydrides include acetic anhydride.

Examples of the phenols include bisphenol A, 2,2'-bishydroxysulfone, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmethane.

Examples of the organic acids include sulfonic acids, sulfinic acids, alkyl sulfuric acids, phosphonic acids, phosphoric esters and carboxylic acids, as disclosed in JP-A No. 60-88942 or JP-A No. 02-96755. Specific examples thereof include p-toluenesulfonic acid, dodecyl benzene sulfonic acid, p-toluenesulfinic acid, ethyl sulfuric acid, phenyl phosphonic acid, phenyl phosphinic acid, phenyl phosphoric acid, diphenyl phosphoric acid, benzoic acid, isophthalic acid, adipic acid, p-toluic acid, 3,4-dimethoxybenzoic acid, phthalic acid, terephthalic acid, 4-cyclohexene-1,2-dicarboxylic acid, erucic acid, lauric acid, n-undecanoic acid and ascorbic acid.

The proportion of the acid anhydrides, phenols and organic acids is preferably from 0.05 to 20% by mass, more preferably from 0.1 to 15% by mass, and particularly preferably from 0.1 to 10% by mass, with respect to the total solid of the lower layer or upper layer.

### 3-B: Surfactant

In order to improve the application properties, and in order to broaden the development conditions for a stable treatment, at least one of the upper layer and the lower layer of the image recording layer according to the present invention may contain various surfactants such as the non-ionic surfactant described in JP-ANo. 62-251740 and JP-ANo. 03-208514, the amphoteric surfactant described in JP-A No. 59-121044 and JP-A No. 04-13149, and fluorine-containing surfactant described in JP-ANo. 62-170950, JP-ANo. 11-288093, JP-ANo. 2004-12770 and JP-ANo. 2006-106723, depending on purposes.

The content of the fluorine-containing surfactant (the total amount when plural types thereof are used) with respect to the total solid of the upper layer or lower layer is preferably from 0.01 to 1% by mass, and more preferably from 0.05 to 0.5% by mass.

Specific examples of the non-ionic surfactant include sorbitan tristearate, sorbitan monopalmitate, sorbitan triolate, stearic acid monoglyceride and polyoxyethylene nonyl phenyl ether. Specific examples of the amphoteric surfactant include alkyl di(aminoethyl)glycine, alkyl polyaminoethyl glycine hydrochloride, 2-alkyl-N-carboxyethyl-N-hydroxyethyl imidazolinium betaine and N-tetradecyl-N,N-betaine surfactants (for example, trade name "AMOGEN K": manufactured by DAIICHI KOGYO CO., LTD.).

The proportion of the non-ionic surfactant or amphoteric surfactant (the total amount when plural types thereof are used) to the total solid of the lower layer or the upper layer is preferably from 0.01 to 15% by mass, more preferably 0.05 to 15% by mass, still more preferably 0.1 to 5% by mass, and the most preferably 0.15 to 2.0% by mass.

### 3-C: Print-out agent and/or colorant.

To at least one of the upper layer and the lower layer of the image recording layer of the present invention, a print-out agent for obtaining a visible image immediately after heating caused by light exposure, or a dye or pigment as an image colorant may be added.

Representative examples of the print-out agent include a combination of a compound that releases an acid owing to heating caused by light exposure (photo-acid releasing agent) and an organic dye capable of forming a salt with the compound. Specific examples thereof include a combination of o-naphthoquinone diazide-4-sulfonic acid halogenide and a salt-forming organic dye described in JP-A No. 50-36209 and JP-A No. 53-8128, and a combination of a trihalomethyl compound and a salt-forming organic dye described in JP-A No. 53-36223, JP-ANo. 54-74728, JP-A No. 60-3626, JP-A No. 61-143748, JP-A No. 61-151644 and JP-A No. 63-58440. Examples of the trihalomethyl compound include an oxazol compound and a triazine compound, each of which exerts excellent stability over time and provides a clear print-out image.

As the image colorant, the salt-forming organic dye and other dyes may be used. Examples of a favorable dye including the salt-forming organic dye include an oil-soluble dye and a basic dye. Specific examples of the image colorant include Oil Yellow #101, Oil Yellow #103, Oil Pink #312, Oil Green BG, Oil Blue BOS, Oil Blue #603, Oil Black BY, Oil Black BS, Oil Black T-505 (trade names, manufactured by ORIENT CHEMICAL INDUSTRIES CO., LTD.), Victoria Pure Blue, crystal violet lactone, crystal violet (CI42555), Methyl violet (CI42535), Ethyl Violet, Rhodamine B (CI145170B), Malachite green (CI42000), and Methylene Blue (CI52015). The dyes described in JP-A No. 62-293247 are particularly preferable.

Such a dye and/or print-out agent may be added in a ratio of from 0.01 to 10% by mass, and preferably from 0.1 to 3% by mass, based on the total solid of the lower layer or the upper layer.

### 3-D: Plasticizer

To at least one of the upper layer and the lower layer of the image recording layer according to the present invention, a plasticizer may be added in order to impart flexibility to a coating film. Example of the plasticizer include oligomers and polymers of butyl phthalyl, polyethylene glycol, tributyl citrate, diethyl phthalate, dibutyl phthalate, dihexyl phthalate, dioctyl phthalate, tricresyl phosphate, tributyl phosphate, trioctyl phosphate, tetrahydrofurfuryl oleate, acrylic acid or methacrylic acid.

The plasticizers (the total amount when plural types them are used) may be added, preferably in a ratio of from 0.5 to 10% by mass, and more preferably in a ratio of from 1.0 to 5% by mass, based on the total solid of the lower layer or the upper layer.

### 3-E: Wax

For the purpose of providing a scratch-resistance, a wax may be added to the upper layer according to the present invention, as a compound that reduces the static friction coefficient at the surface of the upper layer. Specific examples thereof include the compounds having a long chain alkyl carboxylic acid ester as described in US Patent No. 6,117,913 or JP-A No. 2004-12770, which has been proposed by the applicant of the present application.

The amount of the wax to be added is preferably from 0.1 to 10% by mass, and more preferably from 0.5 to 5% by mass, in the upper layer.

### 3-F: Development inhibitor

Examples of other components include various additives. For example, a material (development inhibitor) which is thermally degradable and which does not substantially reduce, in an undegraded state, the solubility of the aqueous alkali solution-soluble resin, such as an onium salt, an o-quinone diazide compound, an aromatic sulfone compound, or an aromatic sulfone ester compound may be added to the upper layer or the lower layer. By using the additive, the inhibition of the dissolution of an image portion to the developer can be improved.

### Formation of planographic printing plate precursor

The image recording layer of a positive-working planographic printing plate precursor used in the method of manufacturing of the present invention is formed by sequentially or simultaneously applying a lower layer coating solution and an upper layer coating solution, which are prepared by dissolving the respective components in a solvent, on a support described below, followed by drying.

Examples of the solvent which is used for preparing the coating solutions for the upper layer and the lower layer include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methylpyrrolidone, dimethyl sulfoxide, sulfolane, γ-butyrolactone and toluene, but not limited thereto. These solvents may be used alone or in a mixture.

Regarding the lower layer and the upper layer, it is preferred that basically the two layers are formed separately.

Examples of a method for forming two layers separately include a method utilizing the difference in solubility to a solvent between the components included in the lower layer and the components included in the upper layer, and a method in which, after applying the upper layer, a solvent is rapidly dried and removed.

In the following, these methods are described in detail, but the method for separately forming two layers is not limited thereto.

Examples of the method utilizing the difference in solubility to a solvent between the components included in the lower layer and the components included in the upper layer include a method in which a solvent which is not capable of dissolving any of the components contained in the lower layer when an coating solution for the upper layer is applied is used. By this, even in a two layer application, the layers are clearly separated from each other to form coating films. For example, the upper layer and the lower layer may be formed separately in such a manner that: a component which is insoluble to a solvent, such as methyl ethyl ketone or 1-methoxy-2-propanol, which is capable of dissolving an alkali-soluble resin that is a component of the upper layer is selected as a component of the lower layer; the lower layer is applied using a solvent which is capable of dissolving the component of the lower layer, followed by drying; and thereafter, the upper layer which mainly contains an alkali-soluble resin is applied by using a solvent such as methyl ethyl ketone or 1-methoxy-2-propanol, followed by drying.

Examples of other methods of forming the upper layer and the lower layer separately include a method in which, after applying the second layer (the upper layer), the solvent of the upper layer is dried extremely rapidly. In this method, in a coating step, a process of blowing a high-pressure air through a slit nozzle arranged in the direction substantially perpendicular to the running direction of the support (web), a process of imparting a heat energy as a conductive heat to the support from the under surface of the support using a roll (heating roll) having a heating medium such as steam provided therein, or a combination of them may be performed after the application of the upper layer. This method involves rapidly removing the solvent after the upper layer has been applied, whereby the dissolution of the lower layer caused by the solvent in the upper layer coating solution is inhibited.

In order to provide a new function, a partial compatibilization at the interface between the upper layer and the lower layer may sometimes be actively performed as long as the effect of the present invention is sufficiently exerted. Both in the above-mentioned method of employing the difference in solvent solubility and in the method of drying the solvent extremely rapidly after application of the second layer, such methods are carried out by adjusting the degree of the partial compatibilization.

The concentrations of the components (total solid including the additives) excluding the solvent in the lower layer coating solution and the upper layer coating solution to be applied on a support are preferably from 1 to 50% by mass, respectively.

As the method of applying the coating solution, a variety of methods may be used, and examples thereof include bar coating, spin coating, spray coating, curtain coating, dip coating, air-knife coating, blade coating and roll coating.

In order to prevent the damage to the lower layer when the upper layer is applied, the method of applying the upper layer is desired to be a non-contact type. Although, as the method generally used for applying a solvent which is a contact type, bar coating may be used, a forward drive application is desired in order to prevent damages to the lower layer.

The coating amount after drying of the lower layer on the support of the planographic printing plate precursor of the present invention is preferably in a range of from 0.5 to 4.0 g/ m², and more preferably in a range of from 0.6 to 2.5 g/ m². When the amount is lower than 0.5 g/ m², decrease in printing durability is caused, and when the amount is higher than 4.0 g/ m², the image reproducibility deteriorates and the sensitivity decreases, which is not preferable.

The coating amount after drying of the upper layer is preferably in a range of from 0.05 to 1.0 g/ m², and more preferably in a range of from 0.08 to 0.7 g/ m². When the amount is lower than 0.05 g/ m², decrease in development latitude and scratch-resistance are caused, and when the amount is higher than 1.0 g/ m², the sensitivity decreases, which is not preferable.

The total coating amount of the lower layer and the upper layer after drying is preferably in a range of from 0.6 to 4.0 g/ m², and more preferably in a range of from 0.7 to 2.5 g/ m². When the amount is lower than 0.6 g/ m², decrease in printing durability is caused, and when the amount is higher than 4.0 g/ m² or lower, the image reproducibility and the sensitivity deteriorate, which is not preferable.

### Support

The support used for the planographic printing plate precursor is preferably a dimensionally-stable plate-shaped material, and examples thereof include paper, plastic-laminated paper, a metal plate (which is made of, for example, aluminum, copper, or the like), a plastic film (which is made of, for example, cellulose triacetate, cellulose propionate, cellulose butyrate, cellulose acetate butyrate, polyethylene terephthalate, polystyrene, polypropylene, polycarbonate, polyvinyl acetal, or the like), and paper or a plastic film on which the above-mentioned metal is laminated or deposited.

Among these, an aluminum plate which has a good dimensional-stability and is relatively inexpensive is particularly preferred. Examples of a suitable aluminum plate include a pure aluminum plate and an alloy plate which contains aluminum as a main component and contains a trace amount of other elements. Examples of other elements contained in the aluminum alloy include silicon, iron, manganese, copper, magnesium, chromium, zinc, bismuth, nickel and titanium. The content of the other elements in the alloy is at most 10% by mass or less. The thickness of the aluminum plate is preferably from about 0.1 to 0.6 mm, more preferably from about 0.15 to 0.4 mm, and particularly preferably from about 0.2 to 0.3 mm.

The aluminum plate may be subjected to various surface treatments such as a roughening treatment or an anodizing treatment.

Prior to roughening of the aluminum plate, the aluminum plate is optionally subjected to a degreasing treatment using a surfactant, an organic solvent, an aqueous alkali solution, or the like for removing the rolling oil on the surface. The roughening treatment of the surface of the aluminum plate is performed by various methods, and examples thereof include a mechanically roughening method, a method of electrochemically dissolving and roughening the surface, and a method of selectively chemically dissolving the surface. As the mechanical method, known methods such as ball milling, brush milling, blast milling or buff milling may be used. Examples of the electrochemical roughening method include a method in which roughening is performed in a hydrochloric acid or nitric acid electrolyte by using an alternating current or a direct current. As disclosed in JP-A No. 54-63902, a method in which both of these are combined may also be used.

In order to improve the water-retaining capacity or the abrasion resistance of the surface, the roughened aluminum plate is optionally subjected to an anodizing treatment after being subjected to an alkali etching treatment and a neutralization treatment as required. As the electrolyte used for anodizing the aluminum plate, various electrolytes that is capable of forming a porous oxide film may be used, and in general, sulfuric acid, phosphoric acid, oxalic acid or mixed acid thereof is used. The concentration of the electrolyte is determined appropriately depending on the type of the electrolyte.

Since the anodizing conditions varies depending on the electrolyte to be used, the conditions can not be generally specified, but usually, the treatment is preferably performed in the following conditions: the concentration of the electrolyte is 1 to 80% by mass; the liquid temperature is from 5 to 70°C; the current density is 5 to 60 A/dm²; the voltage is 1 to 100 V; and the electrolysis time is 10 seconds to 5 minutes. The amount of anodic oxide film produced by anodizing is preferably 1.0 g/m² or more. In a case in which the amount of the anodic oxide film is less than 1.0 g/m², the printing durability is insufficient or, when used as a planographic printing plate, the non-image portion tends to be scratched, which may tend to cause a so-called "scratch stain" in which an ink is attached to the area of a scratch during printing.

After subjected to the anodizing, the surface of the aluminum is subjected to a hydrophilizing treatment as required. Examples of the method of the hydrophilizing treatment include a method of using an alkali metal silicate (for example, sodium silicate aqueous solution) as disclosed in U.S. Patent No. 2,714,066, U.S. Patent No. 3,181,461, U.S. Patent No. 3,280,734 and U.S. Patent No. 3,902,734. In this method, the support is subjected to a dip treatment or an electrolytic treatment with a sodium silicate aqueous solution. Other examples of the method of the hydrophilizing treatment include a method in which the treatment is performed using potassium fluorozirconate as disclosed in JP-A No. 36-22063 or using polyvinyl phosphate as disclosed in U.S. Patent No. 3,276,868, U.S. Patent No. 4,153,461 and U.S. Patent No. 4,689,272.

### Undercoat layer

In a planographic printing plate precursor according to the present invention, an undercoat layer may be optionally provided between the support and the image recording layer. As the component of the undercoat layer, various organic compounds are used, and examples thereof include carboxymethyl cellulose; dextrin; gum arabic; phosphonic acids having an amino group such as 2-amino ethyl phosphonic acid; organic phosphonic acids such as phenyl phosphonic acid, naphthyl phosphonic acid, alkyl phosphonic acid, glycero phosphonic acid, methylene diphosphonic acid or ethylene diphosphonic acid, each of which may have a substituent; organic phosphoric acids such as phenyl phosphoric acid, naphthyl phosphoric acid, alkyl phosphoric acid, or glycero phosphoric acid, each of which may have a substituent; organic phosphinic acids such as phenyl phosphinic acid, naphthyl phosphinic acid, alkyl phosphinic acid or glycero phosphinic acid, each of which may have a substituent; amino acids such as glycine or β-alanine; and amine hydrochlorides having a hydroxyl group such as triethanol amine hydrochloride. These may be used alone, or two or more of these may be used in combination.

The coating amount of the organic undercoat layer is preferably from 2 to 200 mg/m², and more preferably from 5 to 100 mg/m². When the coating amount of the undercoat layer is within the above ranges, a sufficient printing durability is obtained.

### Backcoat layer

A backcoat layer may be provided at the backside of the support of the planographic printing plate precursor according to the present invention, as required. As such a backcoat layer, a coating layer composed of a metal oxide obtained by hydrolysis and polycondensation of the organic polymer compound described in JP-A No. 05-45885 or the organic or inorganic metal compound described in JP-A No. 06-35174 is preferably used. Among these coating layers, a metal oxide coating layer obtained using a silicon alkoxy compound such as Si(OCH₃)₄, Si(OC₂H₅)₄, Si(OC₃H₇)₄ or Si(OC₄H₉)₄, which is inexpensive and easily obtainable, has an excellent resistance to a developer, and is thus particularly preferred.

### Method of manufacturing Planographic printing plate

The planographic printing plate precursor obtained in the above manner is usually subjected to an imagewise light exposure treatment and a development treatment, whereby a planographic printing plate is manufactured. In other words, in a negative-working planographic printing plate precursor which has been exposed to a desired pattern, the solubility of the exposed region to an alkaline developer is improved. Thus, the exposed region is removed to form a non-image portion, and the remaining unexposed portion on the image recording layer becomes an image portion of the planographic printing plate.

### Light exposure step

Examples of a light source of an active ray which is used for light exposure include a mercury lamp, a metal halide lamp, a xenon lamp, a chemical lamp and a carbon arc lamp. Examples of the radiation include an electron beam, an X-ray, an ion beam, and a far-infrared ray. Furthermore, g-line, i-line, deep-UV light and a high-density energy beam (laser beam) are also used. Examples of the laser beam include a helium-neon laser, an argon laser, a krypton laser, a helium-cadmium laser and a KrF excimer laser.

The imagewise exposure may be performed by light exposure through a mask such as a lith film or by a scanning light exposure.

In the present invention, a light source having an emission wavelength in the near-infrared to infrared regions is preferable, and a solid laser or a semiconductor laser is particularly preferable.

### Development step

Next, the development step will be described in detail.

### Specific developer

The treatment liquid which is used in the development step (hereinafter, also referred to as "specific developer") is an aqueous alkali solution which has a pH of from 8.5 to 10.8 and contains an anionic surfactant.

The anionic surfactant used in the specific developer in the present invention contributes to the improvement in processability.

Examples of the anionic surfactant include fatty acid salts, abietic acid salts, hydroxyalkanesulfonates, alkanesulfonates, dialkylsulfosuccinates, linear alkylbenzenesulfonates, branched chain alkylbenzenesulfonates, alkylnaphthalenesulfonates, alkylphenoxyl polyoxyethylene propylsulfonates, polyoxyethylene alkyl sulfophenyl ether salts, N-methyl-N-oleyl taurine sodium salts, N-alkyl sulfosuccinic acid monoamide disodium salts, petroleum sulfonates, sulfated castor oil, sulfated beef tallow oil, sulfuric ester salts of fatty acid alkyl ester, alkyl sulfuric ester salts, polyoxyethylene alkyl ether sulfuric ester salts, fatty acid monoglyceride sulfuric ester salts, polyoxyethylene alkyl phenyl ether sulfuric ester salts, polyoxyethylene styryl phenyl ether sulfuric ester salts, alkyl phosphoric ester salts, polyoxyethylene alkyl ether phosphoric ester salts, polyoxyethylene alkyl phenyl ether phosphate ester salts, partially saponified copolymer of styrene/maleic anhydride, partially saponified copolymer of olefin/maleic anhydride, naphthalene sulfonate formalin condensates, aromatic sulfinic acid salts, and aromatic-substituted polyoxyethylene sulfonic acid salts.

Among these, dialkylsulfosuccinates, alkyl sulfuric ester salts and alkylnaphthalenesulfonates are particularly preferably used.

As the anionic surfactant used for the treatment liquid of the present invention, an anionic surfactant containing sulfonic acid or a sulfonic acid salt is particularly preferable.

The anionic surfactants may be used alone or in combination.

The content of the anionic surfactant in the developer is preferably from 0.5 to 15% by mass, more preferably from 1 to 10% by mass, and most preferably 2 to 10% by mass.

The specific developer according to the present invention is required to have a pH of 8.5 to 10.8. In order to maintain the pH of the developer within the range, it is preferred that a carbonate ion and/or a hydrogen carbonate ion exist as a buffer. Owing to the function of the carbonate ion and/or the hydrogen carbonate ion, the variation of pH is inhibited even when the developer is used for a long time, and decrease in development property, generation of development scum, and the like caused by the pH variation are considered to be inhibited. In order to allow the developer to contain the carbonate ion and/or hydrogen carbonate ion, a carbonate and a hydrogen carbonate may be added to the developer, or the pH may adjusted after a carbonate or hydrogen carbonate is added, to thereby generate a carbonate ion and a hydrogen carbonate ion.

The carbonate and the hydrogen carbonate which may be used for adjusting the pH are not particularly limited, and examples thereof preferably include alkaline metal salts. Examples of the alkaline metal include lithium, sodium and potassium. Sodium is particularly preferred. These may be used alone, or two or more of these may be used in combination.

The pH of the developer may be any pH as long as a buffer effect is generated, and specifically is required to be in a range of from 8.5 to 10.8. When the pH is lower than 8.5, the development property of the non-image portion decreases, and when the pH is higher than 10.8, the throughput capacity is degraded due to the effect of carbonate in the air.

The total amount of the carbonate and the hydrogen carbonate is preferably from 0.3 to 20% by mass, more preferably from 0.5 to 10% by mass, and particularly preferably from 1 to 5% by mass, with respect to the total mass of the aqueous alkali solution. When the total amount is 0.3% by mass or more, the development property and the throughput capacity are not degraded, and when the total amount is 20% by mass or less, precipitation and crystallization are hard to occur, and further, when the treatment of the waste developer is carried out, a gelation is hard to occur during the neutralization, which makes the waste developer treatment easy.

In order to support the minute adjustment of the alkali concentration and the dissolution of non-image portion of the photosensitive layer, other alkali agents, for example, an organic alkali agent may be used in combination. Examples of the organic alkali agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethylene imine, ethylene diamine, pyridine and tetramethyl ammonium hydroxide. An inorganic salt may also be used, and examples thereof include monobasic sodium phosphate, dibasic sodium phosphate, monobasic potassium phosphate, dibasic potassium phosphate, sodium tripolyphosphate, potassium pyrophosphate and sodium hexametaphosphate.

These other alkali agents are used alone, or two or more of these are used in combination.

The treatment liquid of the present invention may contain, in addition to those described above, a wetting agent, a preservative, a chelate compound, an antifoaming agent, an organic acid, an organic solvent, an inorganic acid and an inorganic salt.

It is noted that when the specific developer contains a water-soluble polymer compound, particularly when the treatment liquid is exhausted, the plate surface may tend to become sticky, and therefore, the content of the water-soluble polymer compound in the specific developer according to the present invention is preferably 10 ppm or lower, more preferably 5 ppm or lower, and it is most preferable that the specific developer does not contain a water-soluble polymer compound. Herein, the term "water-soluble polymer compound" refers, for example, to a polymer compound used as a water-soluble binder polymer, and examples thereof include a polymer compound having in the molecule a hydrophilic group that is selected from the group consisting of a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfo group and a phosphate group.

Specific examples thereof include gum arabic, casein, gelatin, starch derivatives, carboxymethylcellulose and sodium salts thereof, cellulose acetate, sodium alginate, vinyl acetate-maleic acid copolymers, styrene-maleic acid copolymers, polyacrylric acids and salts thereof, polymethacrylric acids and salts thereof, homopolymer and copolymer of hydroxyethyl methacrylate, homopolymer and copolymer of hydroxyethyl acrylate, homopolymer and copolymer of hydroxypyropyl methacrylate, homopolymer and copolymer of hydroxy propylacrylate, homopolymer and copolymer of hydroxybutyl methacrylate, homopolymer and copolymer of hydroxybutyl acrylate, polyethylene glycols, hydroxypropylene polymers, polyvinyl alcohols, hydrolyzed polyvinyl acetate having a degree of hydrolysis of 60 mol% or higher, and preferably 80 mol% or higher, polyvinyl formal, polyvinyl butyral, polyvinyl pyrrolidone, homopolymer and copolymer of acrylamide, homopolymer and copolymer of methacrylamide, homopolymer and copolymer of N-methylol acrylamide, polyvinyl pyrrolidone, alcohol-soluble nylon, polyether of 2,2-bis-(4-hydroxyphenyl)-propane and epichlorohydrin.

Examples of the preservative which may be preferably used include phenol or derivatives thereof, formalin, imidazole derivatives, sodium dehydroacetate, 4-isothiazolin-3-one derivatives, benzisothiazolin-3-one, 2-methyl-4-isothiazolin-3-one, benztriazole derivatives, amidine guanidine derivatives, quaternary ammonium salts, pyridine, quinoline, derivatives of guanidines, diazine, triazole derivatives, oxazole, oxazine derivatives, nitrobromoalcohol-based 2-bromo-2-nitropropane-1,3-diol, 1,1-dibromo-1-nitro-2-ethanol and 1,1-dibromo-1-nitro-2-propanol. In order to attain an effect on the sterilization of various molds, two or more of preservatives are preferably used in combination. The amount of the preservatives to be added is an amount in which the preservatives exert a stable effect on bacteria, molds, yeasts or the like, and preferably, although depending on the type of the bacteria, molds, yeasts or the like, in the range of from 0.01 to 4% by mass with respect to the treatment liquid.

Examples of the chelate compound include ethylene diamine tetraacetic acid, potassium salts and sodium salts thereof; diethylene triamine pentaacetic acid, potassium salts and sodium salts thereof; triethylene tetramine hexaacetic acid, potassium salts and sodium salts thereof; hydroxyethyl ethylene diamine triacetic acid, potassium salts and sodium salts thereof; nitrilotriacetic acid, sodium salts thereof; 1-hydroxyethane-1,1-diphosphonic acid, potassium salts and sodium salts thereof; organic phosphonic acids such as amino tri(methylene phosphonic acid), potassium salts and sodium salts thereof; and phosphonoalkane tricarboxylic acids. In place of the above sodium salts or potassium salts of the chelate agent, organic amine salts of the chelate agent are also effectively used. As for the chelate agent, one that exists stably in the formulation of the treatment liquid and does not inhibit the printing performance is selected. The amount of the chelate agent to be added is preferably from 0.001 to 1.0% by mass with respect to the treatment liquid.

### As the antifoaming agent, general silicone based self-emulsifying type, emulsifying type and nonionic compounds having a HLB value of 5 or smaller can be used. Silicon antifoaming agents are preferred. Among these, any of emulsifying and dispersing type compounds and solubilizing type compounds can be used. The content of the antifoaming agent is suitably from 0.001 to 1.0% by mass with respect to the treatment liquid.

Examples of the organic acid include citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid and organic phosphonic acid. The organic acids may be used in a form of alkaline metal salt thereof or ammonium salt thereof. The content of the organic acid is preferably from 0.01 to 0.5% by mass with respect to the treatment liquid.

Examples of the organic solvent include aliphatic hydrocarbons (hexane, heptane, "ISOPAR E, H, G" (trade name; manufacture by Esso Chemical Ltd.) or gasoline, kerosene or the like), aromatic hydrocarbons(toluene, xylene, or the like), halogenated hydrocarbons (methylene dichloride, ethylene dichloride, trichlene, monochlorobenzene or the like) and polar solvents.

Examples of the polar solvents include alcohols (methanol, ethanol, isopropanol, benzyl alcohol, 2-ethoxyethanol, diethylene glycol monoethyl ether, diethylene glycol monohexyl ether, triethylene glycol monomethyl ether, propylene glycol monomethyl ether, ethylene glycol monobenzyl ether, ethylene glycol monophenyl ether, methyl phenyl carbinol, n-amyl alcohol, methyl amyl alcohol, or the like), ketones (acetone, methyl ethyl ketone, cyclohexanone, or the like), esters (ethyl acetate, propyl acetate, butyl acetate, benzyl acetate, methyl lactate, propylene glycol monomethyl ether acetate, diethyl phthalate, butyl levulinate, or the like), and other solvents (triethyl phosphate, tricresyl phosphate, N-phenylethanolamine, N-phenyldiethanolamine, or the like).

Examples of the inorganic acid and inorganic salt include phosphoric acid, metaphosphoric acid, monobasic ammonium phosphate, dibasic ammonium phosphate, magnesium nitrate, sodium nitrate, potassium nitrate, ammonium nitrate, sodium sulfate, potassium sulfate, ammonium sulfate, sodium sulfite, ammonium sulfite, sulfuric acid hydrogen sodium and nickel sulfate. The content of the inorganic acid or the inorganic salt is preferably from 0.01 to 0.5% by mass based on the total mass of the treatment liquid.

When the above-mentioned organic solvents are water-insoluble, the solvents may be used after being made water-soluble by using a surfactant or the like. When the developer contains an organic solvent, the concentration of the solvent is desirably less than 40% by mass from the viewpoints of safety and flammability.

### Development conditions

The temperature of the development is usually 60°C or less, and preferably in the range of from about 15 to 40°C. In a development treatment in which an automatic developing machine is used, since the developer may be exhausted as the throughput increases, a replenisher or a fresh developer may be used to recover the throughput capacity.

In a usual development treatment, an alkali development is carried out, the alkali is then removed in the subsequent water washing step, a gumming process is carried out in a gumming step and drying is carried out in a drying step. In contrast, the present invention is characterized in that, by using an aqueous solution containing a carbonate ion, a hydrogen carbonate ion and an anionic surfactant, a pre-water washing, a development and a gumming are carried out at the same time. Accordingly, the pre-washing step is not particularly necessary, and pre-water washing, development and gumming can be carried out by using only one liquid and further in a one-bath, followed by a drying step. After the development, it is preferred that a drying is carried out after removing an excess treatment liquid using a squeeze roller or the like.

The development step may be suitably carried out using an automatic apparatus equipped with a rubbing member. Examples of the automatic apparatus include the automatic apparatus described in JP-A No. 2-220061 and JP-A No. 60-59351, in which a rubbing treatment is carried out while a planographic printing plate precursor which has undergone imagewise light exposure being conveyed, and the automatic apparatus described in US Patent No. 5148746 B, US Patent No. 5568768 B and GB Patent No. 2297719 B, in which a rubbing treatment is carried out on a planographic printing plate precursor which has undergone imagewise light exposure, which is provided on a cylinder, while rotating the cylinder. Among these, an automatic apparatus using, as the rubbing member, a rotating brush roller is particularly preferred.

The rotating brush roller used in the present invention may be selected as required depending on the scratch-resistance of the image portion and further the toughness of the support of the planographic printing plate precursor. As the rotating brush roller, known rollers in which brush materials are planted on a plastic or metal roller may be used. Examples thereof include those described in JP-A No. 58-159533 and JP-A No. 03-100554 and brush rollers as described in JP-A No. 62-167253, in which a metal or plastic groove shaped material on which brush materials are planted in lines is rolled radially without a space on a plastic or metal roll which is a core.

As the brush materials, plastic fibers (for example, synthetic fibers made of polyesters such as polyethylene terephthalate or polybutylene terephthalate, polyamides such as nylon6.6 or nylon6.10, polyacryls such as polyacrylonitrile, poly(meta)alkyl acrylate, polyolefins such as polypropylene or polystyrene) may be used, and those having a diameter of the fiber bristle of 20 to 400 µm and a length of the bristle of 5 to 30 mm may be preferably used.

The external diameter of the rotating brush roller is preferably from 30 to 200 mm, and the circumferential speed at the end of the brush which rubs the printing plate is preferably from 0.1 to 5 m/sec. Plural rotating brush rollers are preferably used.

The rotation direction of the rotating brush roller may be in the same direction as or opposite direction to the direction of conveyance of the planographic printing plate precursor. When two or more rotating brush rollers are used, it is preferred that at least one roller brush roller rotates in the same direction as the direction of conveyance of the planographic printing plate precursor and at least one roller brush roller rotates in the opposite direction to the direction of conveyance of the planographic printing plate precursor, whereby the removal of the photosensitive layer of a non-image portion is further ensured. Further, it is also effective to fluctuate the rotating brush roller in the direction of the rotation axis of the brush roller.

After the development step, it is preferable to carry out a drying steps continuously or discontinuously. The drying step is carried out using hot air, an infrared ray or a far-infrared ray.

One example of the structure of an automatic development apparatus preferably used in a method of manufacturing a planographic printing plate in the present invention is schematically illustrated in Fig. 1. The automatic development apparatus illustrated in Fig. 1 is basically composed of a development unit 6 and a drying unit 10. A planographic printing plate precursor 4 is subjected to development and gumming in a developer tank 20, followed by drying in the drying unit 10. Specifically, in Fig. 1, the planographic printing plate precursor 4 inserted into the automatic development apparatus is carried to the development unit 6 by a conveyance roller (carrying-in roller) 16. In the developer tank 20 in the development unit 6, a conveyance roller 22, a brush roller 24 and a squeeze roller 26 are provided in this order from the upstream in the conveyance direction. Backup rollers 28 are provided appropriately between these rollers. The planographic printing plate precursor 4 is dipped in a specific developer while being carried by the conveyance roller 22, and the planographic printing plate precursor 4 is subjected to development and optional gumming by rotating the brush roller 24, whereby a development treatment is carried out. The planographic printing plate precursor 4 subjected to the development treatment is carried to the subsequent drying unit 10 by the squeeze roller (carrying-out roller) 26. The drying unit 10 is provided with a guide roller 36 and two pairs of skew rollers 38 in this order from the upstream in the conveyance direction. The drying unit 10 is provided with drying means such as warm air feeding means and heating means which are not illustrated, and the planographic printing plate precursor 4 carried to the drying unit 10 by the drying means is dried.

Although the thus-obtained planographic printing plate can be subjected to a printing step, the plate is subjected to a burning treatment when a planographic printing plate having a still higher printing durability is desired. In a case of subjecting the planographic printing plate to burning, the plate is preferably treated with a surface-treatment liquid as described in JP-ANo. 61-2518, JP-ANo. 55-28062, JP-ANo. 62-31859, or JP-A No. 61-159655, before the burning. The planographic printing plate to which the surface-treatment liquid is applied is dried if necessary, and then heated at a high temperature using a burning processor (for example, Burning Processor: "BP-1300" (trade name) available from Fuji Photo Film Co., Ltd.) or the like. In this case, although it depends on the types of components that are forming the image, the heating is preferably performed at a temperature of 180 to 300°C for about 1 to 20 minutes. The heating conditions are appropriately selected based on the types of the planographic printing plate precursor to be used. Generally, when the temperature is too low or when the heating time is not sufficient, a sufficient effect of strengthening an image is not obtained, and when the temperature is too high or the heating time is too long, problems such as degradation of a support or thermal decomposition of an image portion may arise.

The thus-obtained planographic printing plate is subjected to an offset printing machine, which is used for printing a large number of sheets.

### EXAMPLES

In the following, the present invention is described in detail by way of Examples, but not limited thereto.

### Manufacture of planographic printing plate precursor 1 (present invention) Alkali-soluble resin (I) used for lower layer

AN-phenyl maleimide/methacrylic acid/methacrylamide copolymer (polymerization molar ratio = 60/15/25: weight-average molecular weight 50,000): represented as "resin 1" in Table 1.

### Synthesis example 1: Synthesis of water-insoluble and alkali-soluble resin 1 (resin 1) used for upper layer

A diisocyanate and a diol shown below were allowed react with each other at a molar ratio (diisocyanate : diol) of 1:1.2, to thereby obtain an alkali-soluble polyurethane resin having in the molecule a carboxyl group (water-insoluble and alkali-soluble resin 1: weight-average molecular weight = 12,000).

| | | Ratio |
|---|---|---|
| 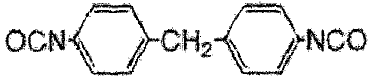 | 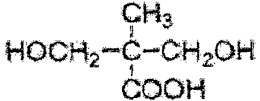 | 75mol% |
| | 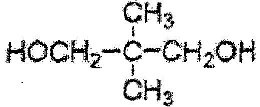 | 25mol% |
| Diisocyanate : Diol = 1:1.2 Molecular weight=12,000 | | |

### Synthesis example 2: Synthesis of alkali-soluble resin 2 (resin 2) used for upper layer 1-1. Synthesis of polymer compound containing polymerizable monomer

To 150 g of dioxane solvent, 15.5 g of methacryloyloxyethyl isocyanate and 12.0 g of 4-aminophenol were added and dissolved, and then the resultant solution was stirred for two hours, thereby obtaining 25.0 g of 2-(N'-(4-hydroxyphenyl)ureide)ethyl methacrylate capable of forming the a constitutional unit.

The obtained 2-(N'-(4-hydroxyphenyl)ureide)ethyl methacrylate and N-phenyl maleimide were polymerized at a mass ratio (2-(N'-(4-hydroxyphenyl)ureide)ethyl methacrylate /N-phenyl maleimide) of 75/25, thereby obtaining 20 g of a water-insoluble and alkali-soluble resin 2 (weight-average molecular weight (Mw) = 16,000).

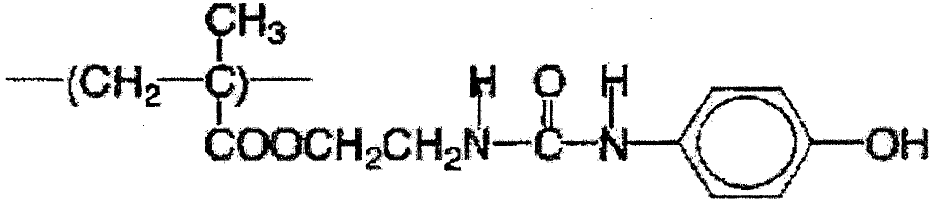

### Manufacture of support A

An aluminum plate (aluminum alloy containing Si: 0.06% by mass, Fe: 0.30% by mass, Cu: 0.014% by mass, Mn: 0.00 1 % by mass, Mg: 0.001 % by mass, Zn: 0.00 1 % by mass, Ti: 0.03% by mass, and the balance: Al and inevitable impurities) having a thickness of 0.24 mm was subjected to the surface treatments mentioned below.

By using an alternating voltage of 60 Hz, an electrochemical roughening treatment was sequentially performed. Here, the electrolyte was a 10 g/liter nitric acid aqueous solution (containing 5g/liter of aluminum ion and 0.007% by mass of ammonium ion) at a temperature of 80°C. After water washing, the aluminum plate was subjected to an etching treatment by spraying at a concentration of caustic soda of 26% by mass and a concentration of aluminum ion of 6.5% by mass at 32°C, so as to dissolve the aluminum plate by 0.20 g/m², followed by water washing by spraying. Thereafter, the aluminum plate was subjected to a desmut treatment by spraying with a 25% by mass aqueous solution of sulfuric acid (containing 0.5% by mass of aluminum ion) at a temperature of 60°C, followed by water washing by spraying.

By using an anodizing device for a two-step supplying electrolytic treatment, anodizing was performed. As the electrolyte supplied to an electrolysis unit, sulfuric acid was used. Thereafter, water washing by spraying was performed. The final amount of the oxide film was 2.7 g/m².

The aluminum support obtained by the anodizing treatment was subjected to an alkali metal silicate treatment (silicate treatment) by dipping the aluminum support in a treatment bath of 1% by mass aqueous solution of sodium silicate No. 3 at a temperature of 30°C for 10 seconds. Thereafter, water washing by spraying was performed.

To the thus-obtained aluminum support which had been subjected to the alkali metal silicate treatment, an undercoating liquid mentioned below was applied, and then the coating film was dried at 80°C for 15 seconds, thereby obtaining a support A provided with an undercoat layer. The amount of coating film after drying was 15 mg/m².

### Undercoating liquid

- β-Alanine 0.5 g
- Methanol 95 g
- Water 5 g

### Formation of image recording layer

### 1. Formation of lower layer

To the support A thus obtained, a lower layer coating solution 1 having the formulation mentioned below was applied using a bar coater in such a manner that the coating amount thereof was 1.5g/m², and then, the support was dried at 160°C for 44 seconds, followed by immediate cooling by cool air having a temperature of 17 to 20°C until the temperature of the support became 35°C.

### Lower layer coating solution 1

- Styrene-acrylonitrile copolymer (73.5/26.5) [trade name: SAN32, manufactured by Bayer] 0.3 g
- Alkali-soluble resin (I) [In Table 1, shown as "resin I"] 0.5 g
- Cyanine dye A (structure shown below) 0.017 g
- Crystal violet [manufactured by Hodogaya Chemical Co., Ltd.] 0.015 g
- MEGAFACE F-177 [manufactured by DAINIPPON INK AND CHEMICALS Inc., fluorine-containing surfactant] 0.05 g
- γ-Butyrolactone 10 g
- Methyl ethyl ketone 10 g 1-Methoxy-2-propanol 8 g

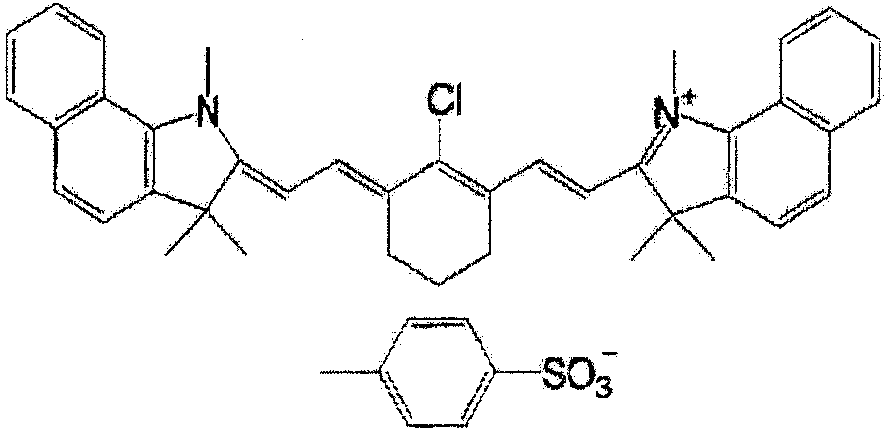

### 2. Formation of upper layer

Subsequently, an upper layer coating solution 1 having the formulation mentioned below was applied using a bar coater in such a manner that the coating amount thereof was 0.5g/m², and then, the layer was dried at 130°C for 40 seconds, followed by gradual cooling by air having a temperature of 20 to 26°C, thereby forming an upper layer. In this manner, a planographic printing plate precursor 1 including an image recording layer having a multilayered structure of the lower layer and the upper layer was manufactured.

### Upper layer coating solution 1

- Water-insoluble and alkali-soluble resin 1 (compound obtained in Synthesis example 1) [In Table 1, described as "resin I"] 30.0 g
- Crystal violet (C.I.42555) 0.03 g
- MEGAFACE F-177 0.05 g
- 3-Pentanone 60 g
- Propylene glycol monomethyl ether-2-acetate 8 g

### Planographic printing plate precursor 2: present invention

A planographic printing plate precursor 2 was manufactured in the same manner as the planographic printing plate precursor 1, except that the water-insoluble and alkali-soluble resin 1 used in the upper layer coating solution 1 for the planographic printing plate precursor 1 was changed to the water-insoluble and alkali-soluble resin 2 (in Table 1, shown as "resin II") obtained in Synthesis example 2.

### Planographic printing plate precursor 3: present invention

A planographic printing plate precursor 3 was manufactured in the same manner as the planographic printing plate precursor 1, except that the alkali-soluble resin (I) used in the lower layer coating solution 1 for the planographic printing plate precursor 1 was changed to m,p-cresol novolac (m /p ratio = 6/4, weight-average molecular weight: 4,500, containing 0.8% by mass of unreacted cresol; alkali-soluble novolac resin which is shown, in Table 1, as "novolac resin").

### Planographic printing plate precursor 4: present invention

A planographic printing plate precursor 4 was manufactured in the same manner as the planographic printing plate precursor 1 except that the styrene-acrylonitrile copolymer SAN32 in the lower layer of the planographic printing plate precursor 1 was changed to a styrene/acrylonitrile/methacrylic acid copolymer (polymerization molar ratio = 69/25/6: alkali-soluble acrylic resin which is shown, in Table 1, as "acrylic resin").

### Planographic printing plate precursor 5: present invention

A planographic printing plate precursor 5 was manufactured in the same manner as the planographic printing plate precursor 1 except that the content of the water-insoluble and alkali-soluble resin 1 in the upper layer was changed to 15.0 g (half amount), and 15.0 g of the alkali-soluble novolac resin used for the planographic printing plate precursor 3 was added.

### Planographic printing plate precursor C1: Comparative example

A comparative planographic printing plate precursor C1 (Comparative example) was manufactured in the same manner as the planographic printing plate precursor 1 except that, in place of the styrene-acrylonitrile copolymer SAN32 in the lower layer of the planographic printing plate precursor 1, the same amount of the alkali soluble resin (I) was added thereto.

### Examples 1 to 7 and Comparative Examples 1 to 3 Plate making and evaluation of planographic printing plate Exposure step

The thus-obtained planographic printing plate precursors 1 to 5 of the present invention and the comparative planographic printing plate precursor C1 were subjected to light exposure (laser power: 8.5 W, revolution: 185 rpm) using an exposure device (Trendsetter F (trade name ), manufactured by Kodak).

For evaluating a development scum, overall exposure was performed to produce a clear image.

### Development step

The planographic printing plate precursors after the light exposure were each subjected to a development treatment at a temperature of 30°C using an automatic development apparatus as illustrated in Fig. 1 [developer tank 25L, plate conveyance speed: 100 cm/min, a brush roller having an outer diameter of 50 mm on which polybutylene terephthalate fibers (fiber diameter 200µm, fiber length 17 mm) were planted was rotating at 200 revolutions per minute in the same direction as the conveyance direction (peripheral speed at the end of the brush: 0.52 m/sec), drying temperature: 80°C] and using a developer shown in Table 1, until the throughput became 20 m²/L.

Specific developer 1

| | |
|---|---|
| Water | 8963.8 g |
| Sodium carbonate | 200 g |
| Sodium hydrogen carbonate | 100 g |
| NEWCOL B4SN (61 % aqueous solution) | 656 g |
| (trade name: polyoxyethylene naphthyl ether sulfuric acid salt manufactured by Nippon Nyukazai Co., Ltd.) | |
| EDTA 4Na | 80 g |
| 2-Bromo-2-nitropropane-1,3diol | 0.1 g |
| 2-Methyl-4-isothiazolin-3-one | 0.1 g |
| (pH: 9.7) | |

Specific developer 2

| | |
|---|---|
| Water | 8665 g |
| Potassium carbonate | 150 g |
| Potassium hydrogen carbonate | 80 g |
| ELEMINOL MON (47% aqueous solution) | 745 g |
| (trade name: sodium dodecyl diphenyl ether disulfonate, manufactured by Sanyo Chemical Industries, Ltd., anionic surfactant) | |
| Monobasic ammonium phosphate | 180 g |
| Sodium hexametaphosphate | 180 g |
| (pH: 9.7) | |

Specific developer 3

| | |
|---|---|
| Water | 8150.8 g |
| Sodium carbonate | 200 g |
| Sodium hydrogen carbonate | 80 g |
| PELEX NBL (35% aqueous solution) | 1429 g |
| (trade name: Sodium alkyl naphthalene sulfonate, anionic surfactant manufactured by Kao Corporation) | |
| Citric acid | 40 g |
| Monobasic ammonium phosphate | 20 g |
| Propylene glycol | 80 g |
| 2-Bromo-2-nitropropane-1,3diol | 0.1 g |
| 2-Methyl-4-isothiazolin-3-one | 0.1 g |
| (pH: 9.8) | |

Comparative developer 1

| | |
|---|---|
| Water | 9779.8 g |
| Sodium carbonate | 130 g |
| Sodium hydrogen carbonate | 70 g |
| Monobasic ammonium phosphate | 20 g |
| 2-Bromo-2-nitropropane-1,3 diol | 0.1 g |
| 2-Methyl-4-isothiazolin3-one (pH: 9.7) | 0.1 g |

### Development scum evaluation I (number of adhered scum)

The planographic printing plate precursor which had undergone the overall light exposure for evaluating the development scum was subjected to a development treatment using an automatic developing machine. After the development treatment, the number of scum adhered on the plate was counted by visual inspection. The results are shown in Table 1 below. The unit is [number/m²].

### Development scum evaluation 2 (deposited scum)

After the treatment described in the above-mentioned development step was carried out, the automatic developing machine was stopped. Then, the developer was removed therefrom, and the presence or absence of insoluble components at the bottom of the developing bath (in Fig. 1 denoted as 6) was observed by visual inspection, and evaluated in accordance with the criteria mentioned below. The results were shown in the item "deposited scum" in Table 1.
A: There was no insoluble component, and the bottom of the tank was clean.
B: Deposition of insoluble components was observed at the bottom of the tank.

### Evaluation of development property

The planographic printing plate obtained through the pattern light exposure and the subsequent development was installed in a printer SOR-M (trade name, manufactured by Heidelberger Druckmaschinen AG), and printing was performed at a printing speed of 6,000 sheets per hour by using dampening water (EU-3 (trade name, an etching liquid manufactured by Fuji Film Corporation)/water/isopropyl alcohol = 1/89/10 (volume ratio)) and Fusion G (N) India ink (trade name, manufactured by DAINIPPON INK AND CHEMICALS Inc.). The generation of scum in the non-image portion on the printed product obtained in this case was observed.

### Evaluation of image formability

In the light exposure step, drawing (light exposure) in a test pattern image including a chart having a halftone dot area ratio of from 1 to 99% in 175 dpi/2400 dpi was performed. Only one planographic printing plate precursor after the light exposure was subjected to a development treatment in the same manner as in the method described in the above-mentioned development step, and then the halftone dot area ratio range in which halftone dots were reproduced was observed using a loupe, and the results were described in the item "image formability" in Table 1.

**Table 1**

| | Planographic printing plate precursor | Lower layer | | Upper layer | Developer | Evaluation result | | | |
|---|---|---|---|---|---|---|---|---|---|
| | | Alkali-soluble resin | Copolymer of styrene and acrylonitrile | Water-insoluble and alkali-soluble resin | | Development scum 1 (number/m²) | Development scum 2 (deposited scum) | Development property | Image formability |
| Example 1 | 1 | Resin I | SAN32 | Resin 1 | Specific developer 1 | 0 | A | No stain | 1-99% |
| Example 2 | 2 | Resin I | SAN32 | Resin 2 | Specific developer 1 | 0 | A | No stain | 1-99% |
| Example 3 | 3 | Novolac resin | SAN32 | Resin 1 | Specific developer 1 | 0 | A | No stain | 1-99% |
| Example 4 | 4 | Resin I | Acrylic resin | Resin 1 | Specific developer 1 | 0 | A | No stain | 1-99% |
| Example 5 | 5 | Resin I / Novolac resin | SAN32 | Resin 1 | Specific developer 1 | 0 | A | No stain | 1-99% |

| Alkali-soluble resin | Copolymer of styrene and acrylonitrile | Water-insoluble and alkali-soluble resin | Development scum 1 (per m²) | Development scum 2 (deposited scum) | Development property | Image formability | | | |
|---|---|---|---|---|---|---|---|---|---|
| Example 6 | 1 | Resin I | SAN32 | Resin 1 | Specific developer 2 | 0 | A | No stain | 1-99% |
| Example 7 | 1 | Resin I | SAN32 | Resin 1 | Specific developer 3 | 0 | A | No stain | 1-99% |
| Comparative Example 1 | Comparative C1 | Resin I | - | Resin 1 | Specific developer 1 | 2 | B | Stain was present | 1-97% |
| Comparative Example 2 | Comparative C1 | - | SAN32 | Resin 1 | Specific developer 1 | 10 | B | Stain was present | 1-95% |
| Comparative Example 3 | 1 | Resin I | SAN32 | Resin 1 | Specific developer 1 | >100 | B | Stain was present | 1-90% |

From the results shown in Table 1, according to the method of manufacturing a planographic printing plate of the present invention, even when a single bath treatment using a weak alkaline developer is carried out, deposition of development scum in a developing apparatus was observed as well as no development scum was adhered on the surface of the plate. Thus, it was found that the generation of scum in the developer tank was inhibited. Furthermore, the development property was excellent, and no stain caused by a residual film in the non-image portion was found. Further, when the planographic printing plate obtained by the manufacturing method of the present invention was used, it was found that the halftone dot reproducibility was favorable, and a printed product having a high image quality was obtained.

On the other hand, in Comparative Examples 1 and 2 which did not contain the specific alkali-soluble resin, and in Comparative Example 3 in which a developer that does not fall within the scope of the present invention was used, the generation of development scum was observed, and stains in the non-image portion was also observed, which means that the development property thereof was inferior to those of Examples.

## Claims

1. A method of manufacturing a planographic printing plate, comprising in the following order:
subjecting a positive-working planographic printing plate precursor to imagewise light exposure, the positive-working planographic printing plate precursor comprising an image recording layer on a support, the image recording layer comprising a lower layer including an infrared absorbing agent, an alkali-soluble resin, and a copolymer at least including a structural unit derived from acrylonitrile and a structural unit derived from styrene, and an upper layer including a water-insoluble and alkali-soluble resin, in this order; and
developing the positive-working planographic printing plate precursor after the imagewise light exposure by using an aqueous alkali solution which has a pH of from 8.5 to 10.8 and which comprises an anionic surfactant.

2. The method of manufacturing a planographic printing plate according to claim 1, wherein the alkali-soluble resin included in the lower layer comprises at least one selected from a phenol resin or an alkali-soluble acrylic resin.

3. The method of manufacturing a planographic printing plate according to claim 1 or 2, wherein the alkali-soluble resin included in the lower layer comprises an alkali-soluble acrylic resin.

4. The method of manufacturing a planographic printing plate according to claim 2, wherein the phenol resin comprises an alkali-soluble novolac resin.

5. The method of manufacturing a planographic printing plate according to any one of claims 1 to 4, wherein the water-insoluble and alkali-soluble resin included in the upper layer comprises at least one selected from the group consisting of an alkali-soluble polyurethane resin, an alkali-soluble resin having a urea bond at a side chain thereof, and an alkali-soluble phenol resin.

6. The method of manufacturing a planographic printing plate according to any one of claims 1 to 5, wherein the content of a water-soluble polymer compound in the aqueous alkali solution is 10 ppm or lower.

7. The method of manufacturing a planographic printing plate according to any one of claims 1 to 6, wherein the content of the anionic surfactant in the aqueous alkali solution is from 0.5% by mass to 15% by mass.

8. The method of manufacturing a planographic printing plate according to any one of claims 1 to 7, wherein the aqueous alkali solution further comprises at least one selected from a carbonate or a hydrogen carbonate.

9. The method of manufacturing a planographic printing plate according to any one of claims 1 to 8, wherein the development step is a single bath treatment using the aqueous alkali solution.

## Patentansprüche

1. Verfahren zur Herstellung einer Flachdruckplatte, umfassend in der folgenden Reihenfolge:
bildweises Belichten eines positiv arbeitenden Flachdruckplattenvorläufers, wobei der positiv arbeitende Flachdruckplattenvorläufer eine Bildaufzeichnungsschicht auf einem Träger umfasst, worin die Bildaufzeichnungsschicht eine untere Schicht, umfassend einen Infrarotabsorber, ein alkalilösliches Harz und ein Copolymer, das mindestens eine aus Acrylnitril abgeleitete Struktureinheit und eine aus Styrol abgeleitete Struktureinheit enthält, und eine obere Schicht, umfassend ein wasserunlösliches und alkalilösliches Harz, in dieser Reihenfolge umfasst; und
Entwickeln des positiv arbeitenden Flachdruckplattenvorläufers nach der bildweisen Belichtung unter Verwendung einer wässrigen Alkalilösung, die einen pH-Wert von 8,5 bis 10,8 aufweist und die ein anionisches Tensid umfasst.

2. Verfahren zur Herstellung einer Flachdruckplatte gemäß Anspruch 1^{.}, worin das in der unteren Schicht enthaltene alkalilösliche Harz mindestens eines umfasst, ausgewählt aus einem Phenolharz und einem alkalilöslichen Acrylharz.

3. Verfahren zur Herstellung einer Flachdruckplatte gemäß Anspruch 1 oder 2, worin das in der unteren Schicht enthaltene alkalilösliche Harz ein alkalilösliches Acrylharz umfasst.

4. Verfahren zur Herstellung einer Flachdruckplatte gemäß Anspruch 2, worin das Phenolharz ein alkalilösliches Novolakharz umfasst.

5. Verfahren zur Herstellung einer Flachdruckplatte gemäß irgendeinem der Ansprüche 1 bis 4, worin das wasserunlösliche und alkalilösliche Harz, das in der oberen Schicht enthalten ist, mindestens eines enthält, das ausgewählt ist aus der Gruppe bestehend aus einem alkalilöslichen Polyurethanharz, einem alkalilöslichen Harz, das eine Harnstoffbindung an einer Seitenkette hiervon aufweist, und einem alkalilöslichen Phenolharz.

6. Verfahren zur Herstellung einer Flachdruckplatte gemäß irgendeinem der Ansprüche 1 bis 5, worin der Gehalt einer wasserlöslichen Polymerverbindung in der wässrigen Alkalilösung 10 ppm oder weniger beträgt.

7. Verfahren zur Herstellung einer Flachdruckplatte gemäß irgendeinem der Ansprüche 1 bis 6, worin der Gehalt des anionischen Tensids in der wässrigen Alkalilösung von 0,5 bis 15 Masse% beträgt.

8. Verfahren zur Herstellung einer Flachdruckplatte gemäß irgendeinem der Ansprüche 1 bis 7, worin die wässrige Alkalilösung ferner mindestens eines umfasst, ausgewählt aus einem Carbonat oder einem Hydrogencarbonat.

9. Verfahren zur Herstellung einer Flachdruckplatte gemäß irgendeinem der Ansprüche 1 bis 8, worin der Entwicklungsschritt eine Behandlung mit einem einzelnen Bad ist, worin die wässrige Alkalilösung verwendet wird.

## Revendications

1. Procédé de fabrication d'une plaque d'impression planographique, comprenant dans l'ordre suivant, le fait :
de soumettre un précurseur de plaque d'impression planographique à fonctionnement de type positif à une exposition à une lumière sous forme d'image, le précurseur de plaque d'impression planographique à fonctionnement de type positif comprenant une couche d'enregistrement d'image sur un support, la couche d'enregistrement d'image comprenant une couche inférieure comportant un agent absorbant l'infrarouge, une résine soluble dans l'alcali, et un copolymère comportant au moins une unité structurale dérivée d'un acrylonitrile et une unité structurale dérivée d'un styrène, et une couche supérieure comportant une résine non hydrosoluble et soluble dans l'alcali, dans cet ordre ; et
de développer le précurseur de plaque d'impression planographique à fonctionnement de type positif après l'exposition à la lumière sous forme d'image en utilisant une solution alcaline aqueuse qui a un pH allant de 8,5 à 10,8 et qui comprend un agent tensioactif anionique.

2. Procédé de fabrication d'une plaque d'impression planographique selon la revendication 1, dans lequel la résine soluble dans l'alcali incluse dans la couche inférieure comprend au moins une résine choisie parmi une résine de phénol ou une résine acrylique soluble dans l'alcali.

3. Procédé de fabrication d'une plaque d'impression planographique selon la revendication 1 ou 2, dans lequel la résine soluble dans l'alcali incluse dans la couche inférieure comprend une résine acrylique soluble dans l'alcali.

4. Procédé de fabrication d'une plaque d'impression planographique selon la revendication 2, dans lequel la résine de phénol comprend une résine novolaque soluble dans l'alcali.

5. Procédé de fabrication d'une plaque d'impression planographique selon l'une quelconque des revendications 1 à 4, dans lequel la résine non hydrosoluble et soluble dans l'alcali incluse dans la couche supérieure comprend au moins une résine choisie dans le groupe constitué d'une résine de polyuréthane soluble dans l'alcali, une résine soluble dans l'alcali présentant une liaison urée au niveau d'une chaîne latérale de celle-ci, et une résine de phénol soluble dans l'alcali.

6. Procédé de fabrication d'une plaque d'impression planographique selon l'une quelconque des revendications 1 à 5, dans lequel la teneur du composé polymère hydrosoluble dans la solution alcaline aqueuse est inférieure ou égale à 10 ppm.

7. Procédé de fabrication d'une plaque d'impression planographique selon l'une quelconque des revendications 1 à 6, dans lequel la teneur de l'agent tensioactif anionique dans la solution alcaline aqueuse est comprise entre 0,5% en masse et 15% en masse.

8. Procédé de fabrication d'une plaque d'impression planographique selon l'une quelconque des revendications 1 à 7, dans lequel la solution alcaline aqueuse comprend en outre au moins un élément choisi parmi un carbonate ou un carbonate d'hydrogène.

9. Procédé de fabrication d'une plaque d'impression planographique selon l'une quelconque des revendications 1 à 8, dans lequel l'étape de développement est un traitement en bain unique utilisant la solution alcaline aqueuse.
